(19) Europäisches Patentamt

European Patent Office

Office européen des brevets

(11) EP 0 848 501 B1

(12) **FASCICULE DE BREVET EUROPEEN**

(45) Date de publication et mention
de la délivrance du brevet:
**04.06.2003 Bulletin 2003/23**

(51) Int Cl.⁷: **H03M 13/23**, H03M 13/00

(21) Numéro de dépôt: **97203685.9**

(22) Date de dépôt: **25.11.1997**

(54) **Système et procédé de transmission numérique comportant un code produit combiné à une modulation multidimensionnelle**

System und Verfahren zur digitalen Übertragung mit einem Produktkode kombiniert mit multidimensionaler Modulation

Digital transmission system and method comprising a product code combined with multidimensional modulation

(84) Etats contractants désignés:
**DE FI FR GB IT SE**

(30) Priorité: **10.12.1996 FR 9615159**

(43) Date de publication de la demande:
**17.06.1998 Bulletin 1998/25**

(73) Titulaire: **Koninklijke Philips Electronics N.V.**
**5621 BA Eindhoven (NL)**

(72) Inventeurs:
• **Chouly, Antoine**
**75008 Paris (FR)**
• **Gianella, David**
**75008 Paris (FR)**

(74) Mandataire: **Landousy, Christian**
**Société Civile S.P.I.D.**
**156, Boulevard Haussmann**
**75008 Paris (FR)**

(56) Documents cités:
**EP-A- 0 051 141        EP-A- 0 052 463**
**EP-A- 0 282 298        EP-A- 0 654 910**
**EP-A- 0 696 108        GB-A- 2 253 974**
**US-A- 5 428 646**

**Description**

L'invention concerne un système de transmission numérique à protection de données d'entrée, comportant des moyens de codage desdites données et des moyens de décodage itératif, les moyens de codage comportant un premier sous-ensemble pour effectuer un codage convolutif systématique en treillis permettant le décodage itératif et un second sous-ensemble pour attribuer les données codées à des symboles d'une modulation numérique.

L'invention concerne également un procédé de protection de données d'entrée mis en oeuvre dans un tel système de transmission numérique.

Le système peut être utilisé pour la transmission numérique pour la télévision par câble, par satellite, pour la diffusion terrestre, pour la transmission sur lignes téléphoniques ou autres.

On connaît des systèmes de protection sélective combinant un codage convolutif avec une modulation numérique. En particulier, pour augmenter les performances d'un tel système en termes de taux d'erreurs binaires, une nouvelle classe de codes convolutifs appelés turbo-codes a été décrite dans le document intitulé: "Near Shannon limit error-correcting coding and decoding: Turbo-codes (1), C. BERROU, A. GLAVIEUX, P. THITIMAJSHIMA, Proceeding of ICC'93, Genève, Mai 1993, pages 1064-1071. Ces turbo-codes ont des performances, exprimées en taux d'erreurs binaires, proches des limites théoriques prévues par Shannon. Il s'agit de codes convolutifs concaténés en parallèle. Ces codes convolutifs sont basés sur des codes récursifs perforés systématiques c'est-à-dire qu'ils découlent de codes de rendement 1/2 pour lesquels un bit d'entrée donne naissance à deux bits de sortie, la perforation étant appliquée aux bits eux-mêmes. La concaténation quant à elle, est réalisée par un entrelacement approprié des données renfermant l'information.

A la réception, le décodage itératif dit décodage turbo, consiste à décoder plusieurs fois les symboles reçus pour améliorer les performances du système en termes de taux d'erreurs binaires. Les décodages itératifs successifs sont effectués par un unique décodeur de Viterbi à décision douce. Ce décodeur est différent d'un décodeur de Viterbi classique qui effectue une décision dure. Dans ce document les décisions douces en sortie du décodeur délivrent un taux de fiabilité d'une décision dure c'est-à-dire une probabilité de décision correcte. Le décodeur est ensuite suivi d'un désentrelacement des données de sortie.

Mais l'utilisation de turbo-codes suivis d'un décodage itératif révélée dans ce document ne supprime pas les limitations des codes systématiques perforés issus de codes de rendement 1/2 surtout lorsque ces derniers sont appliqués séparément de la modulation numérique avec laquelle ils coopèrent. En particulier, un inconvénient de ces codes est qu'ils ne sont adaptés qu'à des modulations à faible efficacité spectrale (inférieure ou égale à deux bits/s/Hz) comme les modulations de phase MDP2 et MDP4. Il leur correspond un débit binaire égal au maximum à deux fois la bande utilisée. Pour augmenter le débit pour une bande occupée fixée, on pourrait chercher à utiliser des modulations à grande efficacité spectrale du type modulation d'amplitude en quadrature (MAQ). Mais l'utilisation des codes convolutifs perforés décrits, juxtaposés à des modulations MAQ, ne donne pas des performances optimales, car ces codes ont été conçus indépendamment de la modulation.

Le but de l'invention est donc d'accroître les performances de tels systèmes de transmission numérique en garantissant un fonctionnement correct du système avec un rapport signal/bruit minimal tout en améliorant leur efficacité spectrale.

Ce but est atteint avec un système dans lequel le premier sous-ensemble met en oeuvre un codage convolutif systématique en treillis de rendement de codage P/(Q.M), M, P et Q étant des entiers avec Q et M supérieurs à 1, le code convolutif systématique étant utilisé pour générer un code produit en blocs avec fermeture du treillis par ajout de données redondantes comportant au moins un bit d'un code de parité, le code produit étant formé de composantes générées par codage de lignes et de colonnes d'une matrice groupant les données codées par le code convolutif systématique, le second sous-ensemble combinant le code produit avec une modulation d'amplitude multidimensionnelle de dimension Q comportant $2^M$ états, le décodage itératif étant un décodage en blocs.

Pour générer, à partir des codes convolutifs systématiques, le code produit ainsi que la redondance ajoutée, les moyens de codage peuvent comporter des moyens, dits machine d'états, définissant des états de sortie, des symboles de redondance à partir d'états d'entrée et des symboles d'information.

Préférentiellement la machine d'états est couplée à une table de lecture pour déterminer les symboles de redondance du code convolutif systématique et les symboles servant à la fermeture du treillis.

Selon l'invention, le système est également caractérisé en ce que les moyens de décodage itératifs comportent au moins deux voies opérant successivement:

- sur une première voie, le système met en oeuvre, à chaque itération de la voie, un premier décodage itératif avec:

   a) des moyens pour calculer des décisions dures se rapportant au code convolutif systématique,
   b) des moyens pour calculer des premières fiabilités des décisions dures associées à chaque sous-ensemble de la modulation multidimensionnelle, et des secondes fiabilités associées au treillis du code convolutif systématique,

c) des moyens pour sélectionner des fiabilités minimales entre les premières et secondes fiabilités de chaque décision,

d) des moyens pour calculer des décisions douces servant à l'itération suivante de la première voie en fonction des fiabilités minimales sélectionnées et des décisions dures,

- et sur une seconde voie, le système met en oeuvre, à chaque itération de la voie:

a) des moyens pour calculer des décisions dures se rapportant au code de parité,

b) des moyens pour calculer des troisièmes fiabilités pour chaque décision dure de la seconde voie en fonction des décisions dures de la première voie,

c) des moyens pour calculer des décisions douces en fonction des troisièmes fiabilités, des décisions douces issues de l'itération précédente de la seconde voie et des décisions dures de la première voie.

L'invention concerne aussi un procédé de protection de données d'entrée mis en oeuvre dans un système de transmission numérique, le procédé comportant une phase de codage desdites données et une phase de décodage itératif, la phase de codage comportant une première étape de codage convolutif systématique en treillis permettant le décodage itératif combinée à une seconde étape d'attribution des données codées à des symboles d'une modulation numérique,

caractérisé en ce que lors de la première étape, le codage systématique en treillis présente un rendement de codage $P/(Q.M)$, M, P et Q étant des entiers avec Q et M supérieurs à 1, le code convolutif systématique étant utilisé pour générer un code produit en blocs avec fermeture du treillis par ajout de données redondantes, le code produit étant formé de composantes générées par codage de lignes et de colonnes d'une matrice groupant les données codées par le code convolutif systématique, la seconde étape combinant le code produit avec une modulation d'amplitude multidimensionnelle de dimension Q comportant $2^M$ états, le décodage itératif étant un décodage en blocs.

Il s'agit d'un codage convolutif systématique de rendement $P/(Q.M)$ préférentiellement de rendement 7/8. Ce codage est combiné avec une modulation numérique multidimensionnelle à $2^M$ états (préférentiellement à 4 états) pour fournir des performances optimales. Selon cet exemple (M=2, Q=8, P=14, rendement =14/16 =7/8), un tel codage est obtenu en traitant un train binaire dans lequel on prend 14 bits ou 7 symboles (dits symboles d'entrée) pour les coder en huit symboles (dits symboles de sortie). Les Q symboles (respectivement les huit symboles) de sortie sélectionnent deux symboles à $2^M$ niveaux (respectivement à quatre niveaux {+1, -1, +3, -3}) c'est-à-dire Q symboles réels de la modulation d'amplitude à $2^M$ niveaux avec M bits de sortie par symbole (respectivement à quatre niveaux 4-AM avec deux bits de sortie par symbole). Le codage produit est réalisé en appliquant le codage convolutif systématique aux lignes et aux colonnes d'une matrice contenant les bits d'information avec fermeture du treillis pour chaque ligne et chaque colonne. Ensuite, les symboles $2^M$ -AM (par exemple 4-AM) issus de la matrice après le codage produit sont combinés 2 par 2 pour générer des symboles MAQ $2^{2M}$ (par exemple MAQ16). Les données codées sont ensuite transmises par une porteuse selon les techniques habituelles.

Pour permettre d'effectuer le décodage turbo à la réception, le codage produit doit être systématique. Pour cela, il faut utiliser des codes convolutifs systématiques c'est-à-dire qu'après codage les symboles d'information en entrée se retrouvent sans changement en sortie.

Les codes convolutifs de rendement $P/(Q.M)$, par exemple 7/8, décrits ci-après, sont conçus de telle façon qu'ils donnent le taux d'erreurs le plus faible pour un rapport signal/bruit donné et ceci spécifiquement pour la modulation 4-AM ou MAQ16.

On obtient ainsi un système ayant les performances optimales à la fois en rapport signal/bruit et en efficacité spectrale en combinant une structure de codeur réalisant de manière optimale le codage convolutif systématique de rendement 7/8 avec la modulation multidimensionnelle.

Selon l'invention, il s'agit bien d'un codage produit utilisant un codage convolutif systématique combiné avec une modulation d'amplitude en quadrature et non pas d'une juxtaposition.

Ce système comporte plusieurs avantages.

Par rapport au système de l'art antérieur utilisant des codes perforés binaires avec une modulation de phase MDP4, on dispose d'une capacité de transmission deux fois plus élevée (efficacité spectrale entre deux et quatre bits/s/Hz);

Le système a une complexité matérielle faible puisqu'un seul décodeur à décision douce est nécessaire pour effectuer le décodage itératif du code produit.

Les codes utilisés sont préférentiellement des codes convolutifs systématiques de rendement 7/8, avec 14 bits en entrée et 16 bits en sortie. La fonction qui génère les 16 bits de sortie en fonction des bits d'entrée et de l'état (mémoire) du codeur a été optimisée en présence de la modulation MAQ16.

Les codes convolutifs systématiques, ayant préférentiellement un rendement 7/8, sont choisis de telle manière que la distance euclidienne minimale de ces codes combinés avec la modulation MAQ16 soit maximale afin d'améliorer les performances. Ceci fait ressortir la combinaison du codage avec la modulation.

Ces différents aspects de l'invention et d'autres encore seront apparents et élucidés à partir des modes de réalisation décrits ci-après.

L'invention sera mieux comprise à l'aide des figures suivantes données à titre d'exemples non limitatifs qui représentent:

Figure 1 : un schéma d'un système de transmission numérique en bande de base selon l'invention.

Figure 2 : un arbre de partition de $A_0$ en sous-ensembles.

Figure 3 : un schéma général d'un codeur de ligne ou de colonne permettant de générer le code produit.

Figure 4 : un schéma d'un système de transmission numérique muni d'un codeur pour coder aussi les symboles de redondance.

Figure 5 : une représentation de l'arbre de partition de la constellation 8-D.

Figure 6 : une représentation du treillis d'un code de rendement 7/8.

Figure 7 : un schéma général d'un codeur convolutif systématique de rendement 7/8 combiné avec un modulation 4-AM 8-D.

Figure 8 : une représentation de l'affectation binaire des symboles 4-AM.

Figure 9 : un schéma montrant un codeur convolutif systématique pour un code à 8 états.

Figure 10 : un schéma montrant un codeur convolutif systématique pour un code à 16 états.

Figure 11 : un schéma d'un exemple particulier de réalisation du codeur représenté sur la figure 7 pour un code de rendement 3/4.

Figure 12 : un schéma pour le calcul des symboles de fermeture du treillis.

Figure 13 : un schéma des moyens de décodage du premier étage selon l'invention.

Figure 14 : une représentation en treillis des sous-ensembles $S_{0,0}$ et $S_{0,1}$.

Figure 15 : un organigramme des différentes étapes du décodage effectué dans le premier étage.

Figure 16 : un schéma des moyens de décodage du second étage selon l'invention.

Figure 17 : une représentation en treillis du code de parité.

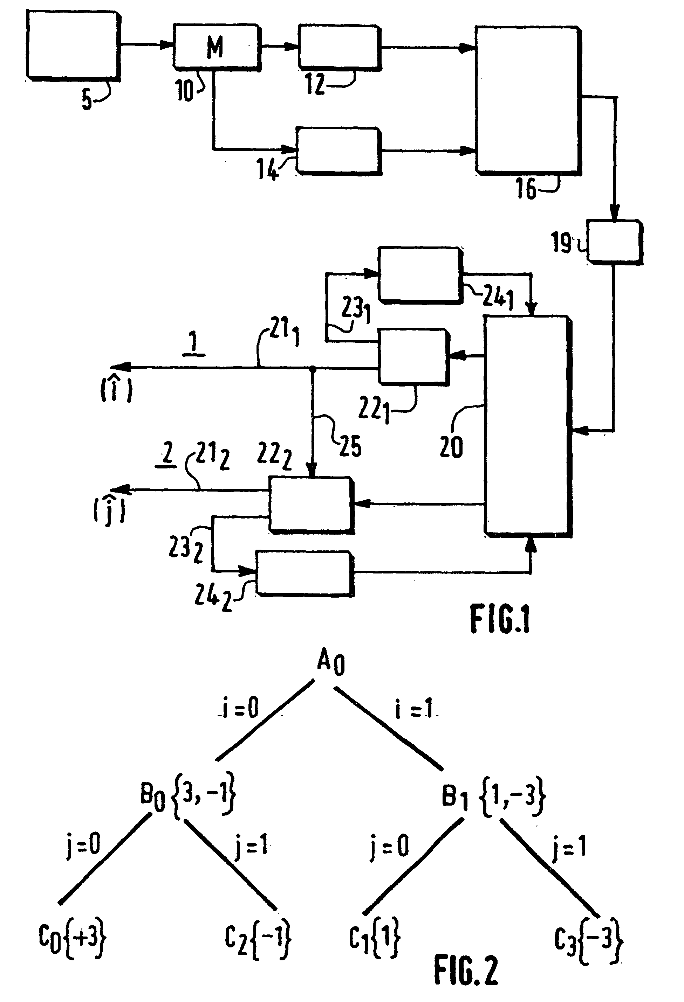

La figure 1 représente un schéma d'un système de transmission numérique en bande de base selon l'invention. Les données d'entrée à protéger issues d'une source 5 sont organisées en matrice par exemple en les stockant dans une mémoire 10 formée de lignes et de colonnes qui peuvent être adressées séparément. Le système comporte des moyens 12 de codage de lignes et des moyens 14 de codage de colonnes. Les deux moyens délivrent des données qui sont affectées à des symboles d'une modulation numérique 4-AM. Un organe d'attribution 16 transforme les symboles 4-AM en symboles MAQ16. Il s'agit d'un groupement 2 par 2 des symboles 4-AM en sortie du codage produit.

Ces symboles sont transmis selon les techniques habituelles à travers un canal 19 vers des moyens de réception. Les données reçues passent dans des moyens 20 de stockage temporaire qui permettent d'effectuer le traitement en boucle décrit ci-après. Le décodeur comporte deux voies opérant successivement, une voie 1 qui se rapporte aux décisions sur les bits les moins significatifs des symboles émis (indice i) et une seconde voie qui se rapporte aux décisions sur les bits les plus significatifs des symboles émis (indice j).

Sur la voie 1, en sortie des moyens de stockage 20, les données entrent dans un décodeur de Viterbi $22_1$ qui présente deux sorties, une sortie $21_1$ à décision dure qui délivre les symboles estimés et les bits i estimés obtenus pour chaque itération et une sortie $23_1$ à décision douce qui est rebouclée sur la mémoire 20 à travers un entrelaceur de données $24_1$.

Sur la voie 2, en sortie des moyens de stockage 20, les données entrent dans un décodeur de code de parité $22_2$ qui présente deux sorties, une sortie $21_2$ à décision dure qui délivre les bits j estimés obtenus pour chaque itération et une sortie $23_2$ à décision douce qui est rebouclée sur la mémoire 20 à travers un entrelaceur de données $24_2$.

Le décodage de la voie 2 est effectué après le décodage de la voie 1, à partir des symboles reçus et des bits i estimés par le décodeur de la voie 1.

Les symboles estimés sont de plus en plus fiables au fur et à mesure que le traitement itératif est répété. En moyenne, cette amélioration, mesurée en taux d'erreurs, est obtenue après 4 à 5 itérations pour la voie 1 et après 2 à 3 itérations pour la voie 2.

Pour former le code produit, le codage d'une ligne de la matrice est effectué de la façon suivante par le codeur de ligne. Les données sont traitées bloc par bloc, un bloc comportant $2 \times (7N + 4)^2$ bits pour un code systématique de rendement 7/8 pris ici à titre d'exemple. La mémoire 10 stocke une matrice [I] d'information de dimensions $(7N + 4) \times (7N + 4)$. La matrice contient des symboles d'information quaternaires {+1, -1, +3, -3}. Chaque symbole correspond à 2 bits.

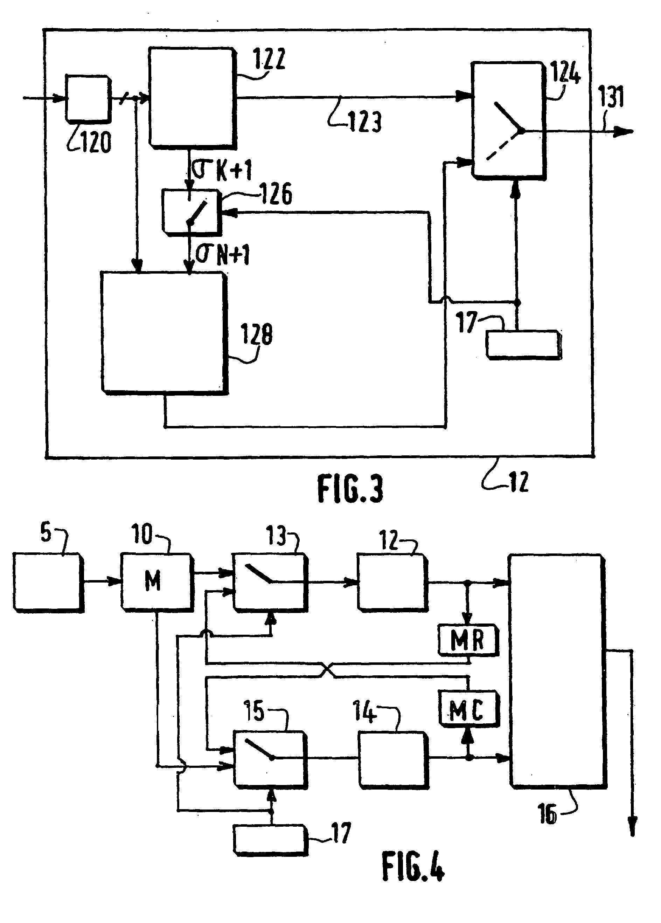

Ensuite chaque ligne de la matrice [I] (1 ligne = 7N + 4 symboles) est codée par un codeur convolutif systématique de ligne 122 (figure 3) générant à la fois les symboles d'information (qui sont les symboles à 4 niveaux 4-AM {+1,-1,+3,-3} correspondant aux symboles quaternaires de la matrice [I] avant codage) et les symboles de redondance. Pour chaque ligne, il y a N symboles 4-AM de redondance générés par le codeur convolutif 7/8 (N symboles de redondance pour 7N symboles d'information) et 4 symboles 4-AM de redondance pour fermer le treillis du code. Ces 4 symboles sont générés avec les 4 derniers symboles de la ligne de la matrice d'information. La même opération est effectuée pour les colonnes de la matrice.

Considérons à titre d'exemple le code convolutif systématique de rendement 7/8 (codeur 122). Avec 7 symboles d'information utile on génère 8 symboles comportant les 7 symboles utiles (code convolutif systématique) plus un symbole de redondance. Considérons la première ligne de la matrice constituée de N +1 blocs (un bloc ayant 7 symboles d'information soit 14 bits) qui sont :

$$(I_{1,1}, \dots I_{1,7}), (I_{1,8}, \dots I_{1,14}), \dots,$$

$$(I_{1,7N-6} \dots I_{1,7N}), (I_{1,7N+1}, \dots I_{1,7N+4}).$$

Un symbole par exemple $I_{1,1}$ comporte deux bits $j_{1,1}$ et $i_{1,1}$.

Le codage produit, réalisé suivant le schéma de la figure 3, donne une matrice représentée sur le tableau I.

| $I_{1,1} \cdots I_{1,7N+4}$ <br> $\cdots\cdots$ <br> $I_{m,1} \cdots I_{m,7N+4}$ <br> $\cdots\cdots$ <br> $I_{7N+4,1} \cdots I_{7N+4,7N+4}$ | $R_{1,1} \cdots R_{1,N}$ <br> $\cdots\cdots$ <br> $R_{m,1} \cdots R_{m,N}$ <br> $\cdots\cdots$ <br> $R_{7N+4,1} \cdots R_{7N+4,N}$ | $TR_{1,1} \cdots TR_{1,4}$ <br> $\cdots\cdots$ <br> $TR_{m,1} \cdots TR_{m,4}$ <br> $\cdots\cdots$ <br> $TR_{7N+4,1} \cdots TR_{7N+4,4}$ |
|---|---|---|
| $C_{1,1} \cdots C_{1,7N+4}$ <br> $\cdots\cdots$ <br> $C_{m,1} \cdots C_{m,7N+4}$ <br> $\cdots\cdots$ <br> $C_{N,1} \cdots C_{N,7N+4}$ | | |
| $TC_{1,1} \cdots TC_{1,7N+4}$ <br> $\cdots\cdots$ <br> $TC_{4,1} \cdots TC_{4,7N+4}$ | | |

**TABLEAU I**

Pour chaque bloc, on calcule le symbole de redondance (soit 2 bits) du code convolutif systématique, le bloc 1 fournit $R_{1,1}$, le bloc 2 fournit $R_{1,2}$, et ainsi de suite jusqu'au bloc N qui fournit

$$R_{1,N}.$$

On suppose que l'état initial du codeur est égal à zéro. Après avoir généré $R_{1,N}$ le codeur 122 est à l'état σ (N). A l'aide des moyens 128 de fermeture du treillis, on ferme le treillis, en forçant l'état du treillis à zéro en générant 4 symboles $TR_{1,1}$, $TR_{1,2}$, $TR_{1,3}$, $TR_{1,4}$ (pour un code à 8 états) correspondant à une transition dans le treillis du code convolutif à 8 états de telle façon qu'après cette transition on arrive à l'état σ=0. Pour un code ayant plus d'états, il faut utiliser plus de symboles de fermeture du treillis. Les symboles $TR_{1,1}$, $TR_{1,2}$, $TR_{1,3}$, $TR_{1,4}$ sont fonction des 4 symboles d'information ($I_{1,7N+1}, ... I_{1,7N+4}$) et de l'état du treillis σ(N) après le codage d'une ligne et sont générés par une table adressée par σ(N) décrite ci-après.

Après le codage, on obtient la matrice de symboles 4-AM représentée dans le tableau I dans lequel:

$I_{m,n}$ est une matrice de dimensions (7N+4) x (7N+4) comportant les symboles 4-AM d'information.

$R_{m,n}$ est une matrice de dimensions (7 N+4) x N comportant les symboles 4-AM correspondant aux symboles de redondance ligne générés par le code 7/8.

$TR_{m,n}$ est une matrice de dimensions (7N+4) x 4 comportant les symboles 4-AM de redondance de ligne de fermeture du treillis.

$C_{m,n}$ est une matrice de dimensions (N x 7N+4) comportant les symboles de redondance colonne.

$TC_{m,n}$ est une matrice de dimensions (4 x 7N+4) comportant les symboles de redondance colonne de fermeture du treillis.

Le codeur de ligne 12 opère de la manière suivante (figure 3). Les symboles d'entrée $I_{m,n}$ entrent dans le buffer 120 puis dans le codeur 122 de rendement 7/8 qui délivre un symbole de redondance pour un bloc de 7 symboles d'information. Un multiplexeur 124 effectue en sortie la mise en série des symboles. Pour cela, il délivre sur sa sortie 131, dans l'ordre, des groupes de 8 symboles, chaque groupe étant formé par les 7 symboles d'information et le symbole de redondance correspondant à ce bloc. Le multiplexeur délivre ensuite tous les groupes de 8 symboles consécutifs. Lorsque tous les groupes sont extraient, il extrait les 4 derniers symboles d'information de la ligne puis les 4 symboles de fermeture du treillis délivrés par l'organe 128 de détermination des symboles de fermeture. Un contrôleur 17 gère les opérations.

Le même traitement est effectué pour les autres lignes. De la même manière, un traitement semblable est réalisé pour les colonnes (codeur de colonnes 14). Le premier bloc de la première colonne est formé des symboles: $I_{1,1}, I_{2,1}.....I_{7N+4,1}$. A chaque bloc de 7 symboles va correspondre un symbole de redondance, par exemple au premier bloc va correspondre le symbole $C_{1,1}$ et au dernier bloc va correspondre le symbole $C_{N,1}$. Les symboles de redondance de fermeture du treillis vont être pour la première colonne les symboles $TC_{1,1}, TC_{2,1}, TC_{3,1}, TC_{4,1}$ générés à partir des symboles $I_{7N+1,1}, .....I_{7N+4,1}$. L'ensemble des données formées par les symboles d'information initiale, les symboles de redondance de codage ligne et de codage colonne et les symboles de fermeture du treillis forment le code produit.

Une ligne de ce code produit va former un bloc de symboles qui sert à coder des symboles d'une modulation 4-AM. Comme les symboles d'information initiale restent les mêmes dans le code produit qu'ils soient lus en ligne ou en colonne, pour utiliser les colonnes du code produit il est inutile d'utiliser une seconde fois les symboles d'information initiale. Seuls donc les symboles de redondance des colonnes du code produit sont utilisés pour coder (codeur de colonnes 14) des symboles d'une modulation 4-AM. Les symboles 4-AM issus des lignes et des colonnes du code produit servent à coder une modulation MAQ16 dans l'organe d'attribution 16.

Pour accroître les performances du système, il est possible de coder aussi les symboles de redondance qui viennent d'être calculés.

Ainsi on peut coder lès colonnes des matrices $R_{m,n}$ et $TR_{m,n}$ (codage en colonne de la redondance ligne) pour générer les matrices $RC_{m,n}$, $TC_{m,n}$, $RCT_{m,n}$ et $TRCT_{m,n}$ de dimensions (N x N), (N x 4), (4 x N) et (4 x 4) respectivement (tableau II). On code aussi en ligne la redondance colonne (matrices $C_{m,n}$ et $TC_{m,n}$) pour générer les matrices $CR_{m,n}$, $CRT_{m,n}$, $TCR_{m,n}$ et $TCR_{m,n}$ de dimensions (N x N), (N x 4), (4 x N) et (4 x 4) respectivement.

Dans ce cas, on code la matrice d'information de dimensions (7N+4)x(7N+4) suivant les lignes et les colonnes pour obtenir la redondance de ligne (symboles $R_{m,n}$ et $TR_{m,n}$) et la redondance colonne (symboles $C_{m,n}$ et $TC_{m,n}$) de la même manière que cela vient d'être décrit. Puis on code en colonne la redondance ligne et en ligne la redondance colonne afin d'accroître les performances du système. Ainsi par exemple, on va coder le bloc de 7N+4 symboles ($R_{1,1},...R_{7N+4,1}$) pour générer d'abord les N symboles de redondance colonne ($RC_{1,1}, ... RC_{N,1}$) provenant de la redondance du code 7/8 puis les quatre symboles de redondance ($RCT_{1,1}$ à $RCT_{4,1}$) de fermeture du treillis. On fait de même pour les autres colonnes de la redondance ligne ($R_{1,n}, ... R_{7N+4,n}$) pour n=1,...N et pour les 4 colonnes ($TR_{1,1}...TR_{7N+4,1}$) jusqu'à ($TR_{1,4},...TR_{7N+4,4}$). On code aussi les lignes de la redondance colonne c'est-à-dire les lignes ($C_{m,1},...C_{m,7N+4}$) pour m=1,...N et les 4 lignes ($TC_{1,1},...TC_{1,7N+4}$) à ($TC_{4,1},...TC_{4,7N+4}$).

On obtient ainsi la matrice suivante :

| $\begin{matrix} I_{1,1}\ldots I_{1,n}\ldots I_{1,7N+4} \\ \ldots\ldots \\ I_{m,1}\ldots I_{m,n}\ldots I_{m,7N+4} \\ \ldots\ldots \\ I_{7N+4,1}\ldots I_{7N+4,n}\ldots I_{7N+4,7N+4} \end{matrix}$ | $\begin{matrix} R_{1,1}\ldots R_{1,N} \\ \ldots\ldots \\ R_{m,1}\ldots R_{m,N} \\ \ldots\ldots \\ R_{7N+4,1}\ldots R_{7N+4,N} \end{matrix}$ | $\begin{matrix} TR_{1,1}\ldots TR_{1,4} \\ \ldots\ldots \\ TR_{m,1}\ldots TR_{m,4} \\ \ldots\ldots \\ TR_{7N+4,1}\ldots TR_{7N+4,4} \end{matrix}$ |
|---|---|---|
| $\begin{matrix} C_{1,1}\ldots C_{1,n}\ldots C_{1,7N+4} \\ \ldots\ldots \\ C_{N,1}\ldots C_{N,n}\ldots C_{N,7N+4} \end{matrix}$ | $\begin{matrix} RC_{1,1}\ldots RC_{1,N} \\ \ldots\ldots \\ RC_{N,1}\ldots RC_{N,N} \end{matrix}$ | $\begin{matrix} TRC_{1,1}\ldots TRC_{1,4} \\ \ldots\ldots \\ TRC_{N,1}\ldots TRC_{N,4} \end{matrix}$ |
| $\begin{matrix} TC_{1,1}\ldots TC_{1,n}\ldots TC_{1,7N+4} \\ \ldots\ldots \\ TC_{4,1}\ldots TC_{4,n}\ldots TC_{4,7N+4} \end{matrix}$ | $\begin{matrix} RCT_{1,1}\ldots RCT_{1,N} \\ \ldots\ldots \\ RCT_{4,1}\ldots RCT_{4,N} \end{matrix}$ | $\begin{matrix} TRCT_{1,1}\ldots TRCT_{1,4} \\ \ldots\ldots \\ TRCT_{4,1}\ldots TRCT_{4,4} \end{matrix}$ |
|  | $\begin{matrix} CR_{1,1}\ldots CR_{1,N} \\ \ldots\ldots \\ CR_{N,1}\ldots CR_{N,N} \end{matrix}$ | $\begin{matrix} CRT_{1,1}, CRT_{1,4} \\ \ldots\ldots \\ CRT_{N,1}\ldots CRT_{N,4} \end{matrix}$ |
|  | $\begin{matrix} TCR_{1,1}\ldots TCR_{1,N} \\ \ldots\ldots \\ TCR_{4,1}\ldots TCR_{4,N} \end{matrix}$ | $\begin{matrix} TCRT_{1,1}\ldots TCRT_{1,4} \\ \ldots\ldots \\ TCRT_{4,1}\ldots TCRT_{4,4} \end{matrix}$ |

TABLEAU II

Dans ce tableau:

- la matrice [I] contient les symboles d'informations d'entrée.
- la matrice [R] est la matrice de redondance ligne de la matrice [I].
- la matrice [C] est la matrice de redondance colonne de la matrice [I].
- la matrice [TR] est la matrice de redondance de fermeture du treillis pour les lignes de la matrice [I].
- la matrice [TC] est la matrice de redondance de fermeture du treillis pour les colonnes de la matrice [I].
- la matrice [RC] est la matrice de redondance colonne de la matrice [R].
- la matrice [CR] est la matrice de redondance ligne de la matrice [C].
- la matrice [TCR] est la matrice de redondance ligne de la matrice [TC].
- la matrice [RCT] est la matrice de redondance de fermeture du treillis pour les colonnes de la matrice [R].
- la matrice [TRC] est la matrice de redondance colonne de la matrice [TR].
- la matrice [TRCT] est la matrice de fermeture du treillis pour les colonnes de la matrice [TR].
- la matrice [CRT] est la matrice de fermeture du treillis des lignes de la matrice [C].
- la matrice [TCRT] est la matrice de fermeture du treillis du codage en ligne de la matrice [TC].

Considérons plus en détail le fonctionnement du codeur de ligne 12 représenté sur la figure 3 pour coder une ligne de la matrice.

On stocke-dans le buffer 120 la ligne qu'on veut coder. Une ligne comporte $(14N + 8)$ bits ou $(7N+4)$ symboles quaternaires d'information. Par exemple pour le bloc d'ordre k, le buffer stocke N blocs $(i_1(k), j_1(k), ..., i_7(k), j_7(k))$ ayant 14 bits (soit 7 symboles) et 1 bloc de 8 bits (soit 4 symboles):

$i_1(N+1), j_1(N+1)$

$i_2(N+1), j_2(N+1)$

$i_3(N+1), j_3(N+1)$

$i_5(N+1), j_5(N+1)$

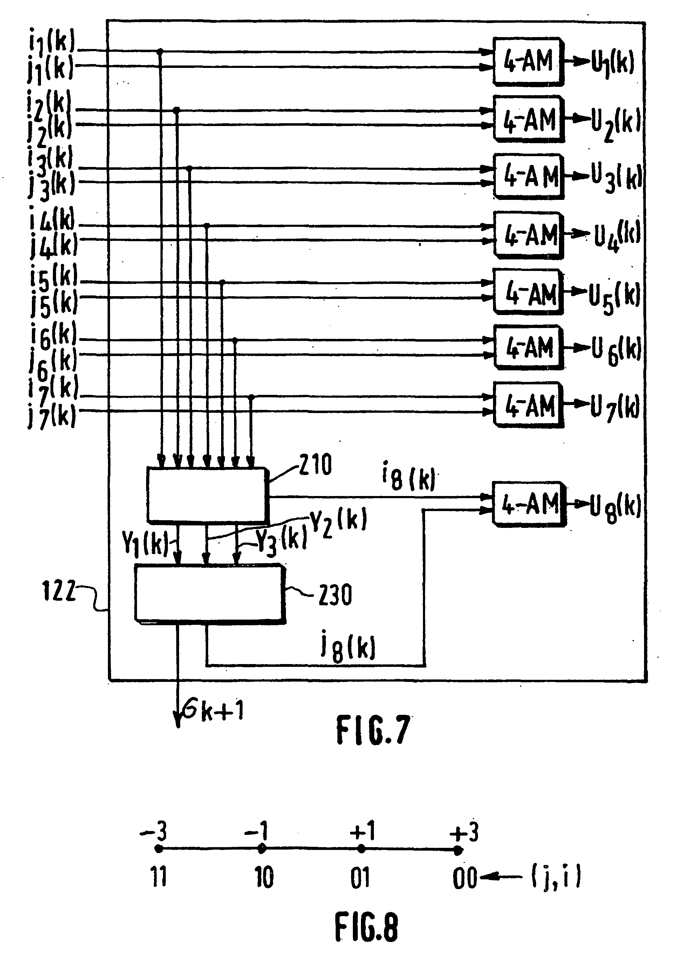

Les N blocs de 14 bits sont soumis successivement à un codage convolutif systématique de rendement 7/8 (codeur 122). Pour chaque bloc (k-ème bloc), le codeur 122 génère 7 symboles 4-AM d'information $U_1(k)$ à $U_7(k)$ correspondant aux 14 bits d'information du bloc et 1 symbole de redondance $U_8(k)$, pour k = 1,...,N, (connexion 123) en réalisant une affectation binaire décrite sur la figure 8.

Chaque bloc de 14 bits d'information correspond à une transition dans le treillis du code 7/8. Le dernier bloc, d'ordre N+1, correspond à la transition qui ferme le treillis.

A partir des 8 bits d'information $\{i_1(N+1), j_1(N+1), i_2(N+1), j_2(N+1), i_3(N+1), j_3(N+1), i_5(N+1), j_5(N+1)\}$, (4 symboles quaternaires) qui sont les 8 derniers bits de la ligne, on génère les symboles 4-AM, c'est-à-dire $U_1(N+1)$, $U_2(N+1)$, $U_3(N+1)$, $U_5(N+1)$ d'après l'affectation binaire donnée par la figure 8, puis on calcule les 4 symboles de redondance $U_4(N+1)$, $U_6(N+1)$, $U_7(N+1)$ et $U_8(N+1)$ permettant de fermer le treillis. Ces symboles sont fonction à la fois de l'état du codeur $\sigma_{N+1}$ après le codage du N-ème bloc et des 8 bits $\{i_1(N+1), j_1(N+1), i_2(N+1), j_2(N+1), i_3(N+1), j_3(N+1), i_5(N+1), j_5(N+1)\}$. Ils sont déterminés par l'organe 128.

Le codeur des colonnes est le même sauf qu'en sortie du codage systématique convolutif 7/8, on a seulement les symboles de redondance.

Le schéma du codeur permettant de faire le double codage de la redondance est représenté sur la figure 4. Les mêmes éléments que ceux de la figure 1 sont représentés avec les mêmes repères. Dans le cas de l'exemple considéré, la mémoire M 10 contient $(7N+4)^2$ symboles. Une autre mémoire MR contient les $(7N+4)(N+4)$ symboles de redondance ligne (symboles $R_{m,n}$, $TR_{m,n}$). Une autre mémoire MC contient les $(N+4)(7N+4)$ symboles de redondance colonne (symboles $C_{m,n}$ et $TC_{m,n}$). Les mémoires MR et MC sont chargées après avoir fini le codage en ligne et en colonne de M. Ensuite, on effectue le codage du contenu de MR suivant les colonnes et le codage du contenu de MC suivant les lignes pour générer les $(N+4)^2$ symboles 4-AM ($RC_{m,n}$, $TRC_{m,n}$, $RCT_{m,n}$ et $TRCT_{m,n}$) et les $(N+4)^2$ symboles 4-AM ($CR_{m,n}$, $CRT_{m,n}$, $TCR_{m,n}$, et $TCRT_{m,n}$) respectivement. Des permutateurs 13 et 15 assurent le déroulement des opérations sous le contrôle d'un contrôleur 17.

Finalement tous les symboles 4-AM formés pour chaque matrice du code produit des tableaux I ou II sont regroupés 2 par 2 et transmis sur le canal sous la forme de symboles complexes de la constellation MAQ16 (suivant un ordre bien défini).

Le rendement du code produit sans codage de la redondance est égal à:

$$\rho_1 = \frac{(7N+4)^2}{(7N+4)^2 + 2(7N^2 + 32N + 16)}.$$

Pour N=20, le rendement est de 0,765 et l'efficacité spectrale est alors égale à 4 fois ce rendement, soit 3,06 bits/s/Hz.

Avec un double codage de la redondance le rendement du code produit devient égal à :

$$\rho_2 = \frac{(7N+4)^2}{16(N+4)(N+1) + (7N+4)^2}.$$

Ainsi avec N=20 on obtient un rendement de 0,72 et une efficacité spectrale de 2,88 bits/s/Hz. Il y a une perte d'efficacité spectrale à coder la redondance de 0,18 bit/s/Hz mais on accroît les performances du système.

La figure 8 représente l'affectation binaire des bits i,j aux symboles de la constellation 4-AM.

La constellation 4-AM à une dimension 1-D est représentée par l'ensemble $A_0 = \{-3,-1,+1,+3\}$. Le premier niveau de partition de $A_0$ comporte deux sous-ensembles $B_0$ et $B_1$ avec $B_0 = \{3,-1\}$ et $B_1 = \{1,-3\}$ (figure 2). Un symbole, par exemple $I_{1,1}$ comporte deux bits $i_{1,1}$ et $j_{1,1}$. Le bit i est affecté à ce premier niveau avec i=0 pour $B_0$ et i=1 pour $B_1$.

Le second niveau de partition de $A_0$ comporte quatre sous-ensembles $C_0$, $C_1$, $C_2$ et $C_3$, avec $C_0 = \{+3\}$, $C_1 = \{+1\}$, $C_2 = \{-1\}$ et $C_3 = \{-3\}$. L'indice j est affecté à ce second niveau avec j=0 pour $C_0$ ou $C_1$ et j=1 pour $C_2$ ou $C_3$. L'indice des ensembles C est égal à la valeur décimale des indices j,i, soit 2j+i, affectés à la partition qui les génère.

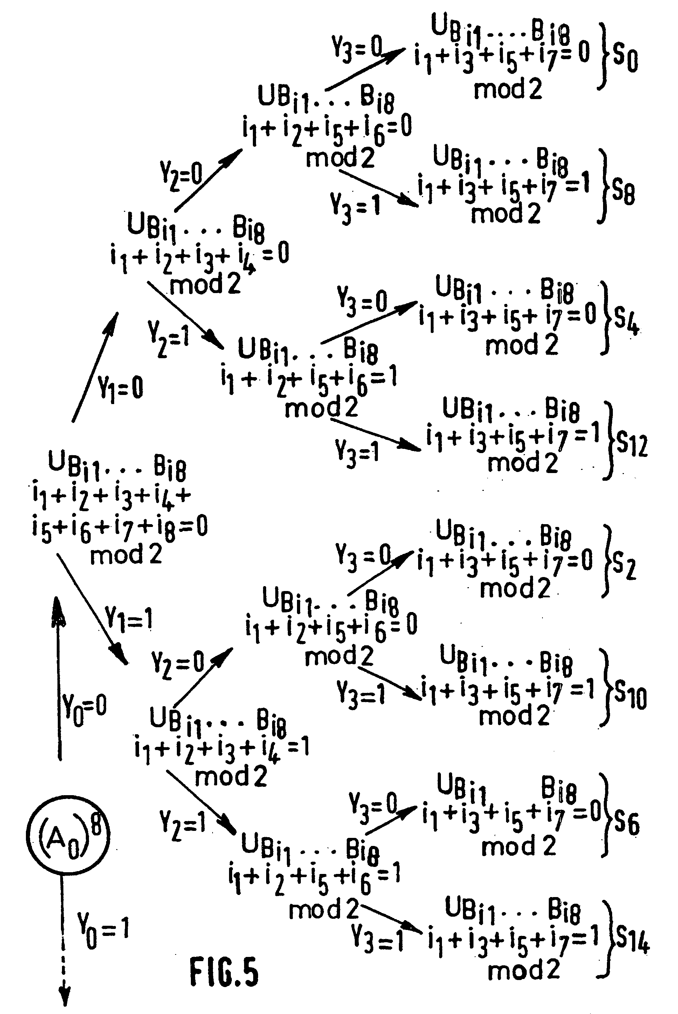

Une constellation 8-D est définie comme étant l'ensemble des blocs de 8 symboles appartenant chacun à $A_0$. La figure 5 représente l'arbre de partition de la constellation 8-D $(A_0)^8$ où $A_0$ est la constellation (1-D) à une dimension 4-AM.

L'ensemble $(A_0)^8$ a pour distance euclidienne minimale (au carré) $do^2$. Cet ensemble est partitionné en 2 sous-ensembles de distance minimale $2do^2$. A chaque sous-ensemble, on affecte un bit $Y_o$ valant 0 ou 1.

$Y_0 = 0$ pour le sous-ensemble constitué par tous les blocs appartenant à $B_{i1} ... B_{i8}$ avec

$$\sum_{k=1}^{8}$$

$i_k$ = 0 mod2;

$Y_0$ = 1 pour le sous-ensemble constitué par tous les blocs appartenant à $B_{i1}$ ... $B_{i8}$ avec

$$\sum_{k=1}^{8}$$

$i_k$ = 1 mod2

Donc $Y_0$ = 0 correspond à l'ensemble de tous les blocs de symboles 4-AM ($U_1$...$U_8$) contenant un nombre pair de composantes dans le sous-ensemble 1-D soit $B_1$ = {+1,-3}.

De même, $Y_0$ = 1 correspond à l'ensemble de tous les blocs de symboles 4-AM ($U_1$...$U_8$) contenant un nombre impair de composantes dans le sous-ensemble 1-D soit $B_1$ = {-1,+3}.

Puis chaque sous-ensemble 8-D est à son tour partitionné en 2 autres sous-ensembles 8-D et ainsi de suite.

A chaque niveau de partition on affecte un bit:

- $Y_0$ est affecté au 1er niveau;
- $Y_1$ est affecté au 2ème niveau;
- $Y_2$ est affecté au 3ème niveau;
- $Y_3$ est affecté au 4ème niveau.

Dans la suite, on va décrire seulement les sous-ensembles correspondant à $Y_0$ = 0.

Après le 4ème niveau de partition, on obtient les 8 sous-ensembles :

$S_0$, $S_2$, $S_4$, $S_6$, $S_8$, $S_{10}$, $S_{12}$, $S_{14}$ ($S_i$, i pair).

L'indice i d'un sous-ensemble $S_i$ est la valeur décimale des 4 bits $Y_3$, $Y_2$, $Y_1$, $Y_0$ affectés à $S_i$.

Chaque sous-ensemble est de la forme $U(B_{i1}...B_{i8})$ (union des sous-ensembles) et est défini par des relations de parité sur les indices ($i_1$, ... $i_8$). La distance minimale (carré) dans chaque sous-ensemble $S_i$ est $4do^2$. Chaque sous-ensemble contient $2^{12}$ = 4096 blocs de 8 symboles 4-AM.

Chaque sous-ensemble $S_i$ contient 16 sous-ensembles ($B_{i1}...B_{i8}$) et chaque sous-ensemble ($B_{i1}...B_{i8}$) contient $2^8$ = 256 blocs 8-D.

Finalement, chaque sous-ensemble $S_i$ est partitionné en 2 sous-ensembles $S_{i,0}$ et $S_{i,1}$ où:

- $S_{i,0}$ est le sous-ensemble des blocs de $S_i$ dont le dernier symbole 4-AM du bloc est positif (donc appartenant à $C_0$ ou $C_1$).
- $S_{i,1}$ est le sous-ensemble des blocs de $S_i$ dont le dernier symbole 4-AM du bloc est négatif (donc appartenant à $C_2$ ou $C_3$).

Donc $S_{i,0}$ correspond à l'ensemble des blocs 8-D de $S_i$ dont le dernier symbole $U_8$ est dans $C_0$ ou $C_1$, c'est-à-dire que le dernier symbole correspond au bit $j_8$ = 0, $S_{i,0}$ contient $2^{11}$ éléments.

$S_{i,1}$ = {($U_1$, ... $U_8$) de $S_i$ tel que $j_8$ = 1}.

Par exemple, le sous-ensemble $S_{6,1}$ est défini par l'ensemble des blocs ($U_1$, $U_2$, ... $U_8$) de $(A_0)^8$ vérifiant $j_8$ = 1 et les 4 relations de parité sur les bits $i_1$ à $i_8$ :

$$i_1 \oplus i_3 \oplus i_5 \oplus i_7 = 0,$$

$$i_1 \oplus i_2 \oplus i_5 \oplus i_6 = 1,$$

$$i_1 \oplus i_2 \oplus i_3 \oplus i_4 = 1,$$

$$\sum_{p=1}^{8} i_p = 0 \quad .$$

où $(i_p, j_p)$ sont les bits affectés au symbole 4-AM $U_p$ (figure 8).

Dans le cas général, pour i pair, $S_{i,j}$ est l'ensemble des blocs U =($U_1$, ..., $U_8$) de symboles 4-AM vérifiant les relations de parité suivantes:

$$i_1 \oplus i_3 \oplus i_5 \oplus i_7 = Y_3$$

$$i_1 \oplus i_2 \oplus i_5 \oplus i_6 = Y_2$$

$$i_1 \oplus i_2 \oplus i_3 \oplus i_4 = Y_1$$

$$i_1 \oplus i_2 \oplus i_3 \oplus i_4 \oplus i_3 \oplus i_6 \oplus i_7 \oplus i_8 = Y_0 = 0$$

$$j_8 = j$$

où ($Y_3$ $Y_2$ $Y_1$ $Y_0$) est la représentation binaire de i, c'est-à-dire: i = $8Y_3 + 4Y_2 + 2Y_1 + Y_0$, avec $Y_0 = 0$ et $(i_p, j_p)$ est l'affectation binaire du p-ème symbole du bloc

$$U_p : \begin{cases} i_p = 0 \ si \ U_p = 3 \ \acute{o}u \ -1 \\ i_p = 1 \ si \ U_p = 1 \ ou \ -3 \end{cases}$$

$$\begin{cases} j_p = 0 \ si \ U_p = 1 \ ou \ 3 \\ j_p = 1 \ si \ U_p = -1 \ ou \ -3 \end{cases}$$

Donc pour générer tous les blocs de $S_{i,j}$ ($2^{11}$ blocs), il suffit de balayer toutes les combinaisons possibles des 11 bits $i_1$, $i_2$, $i_3$, $i_5$, $j_1$, $j_2$, $j_3$, $j_4$, $j_5$, $j_6$ et $j_7$. Pour une combinaison donnée, les autres bits ($i_4$, $i_6$, $i_7$, $i_8$, $j_8$) sont calculés à partir des relations de parité du sous-ensemble $S_{i,j}$ définis ci-dessus.

Le code convolutif systématique de rendement 7/8 est construit de la façon suivante :

- Les sous-ensembles $S_{i,j}$ sont affectés aux branches parallèles du treillis. De plus, les sous-ensembles $S_{i,j}$ avec i pair sont utilisés. Ceci assure une distance minimale (le carré) égale à $4do^2$ où do est la distance minimale de la constellation 4-AM.

- Pour avoir un code de rendement 7/8, on doit avoir 8 transitions distinctes provenant d'un état donné du codeur, ce qui correspond à 14 bits d'entrée (dont 3 bits codés et 11 bits non codés) pour 8 symboles 4-AM (soit 16 bits) transmis. Par conséquent, le treillis d'un code à 8 états est entièrement connecté.

- Pour avoir un code systématique, c'est-à-dire faire que les 7 premiers symboles 4-AM du bloc 8-D transmis soient les 7 symboles (ou 14 bits) d'information, il faut que les $2^{14}$ transitions provenant d'un état génèrent $2^{14}$ blocs de 8 symboles 4-AM, les 7 premiers prenant les $2^{14}$ combinaisons possibles. Pour cela, il suffit d'affecter aux 8 branches distinctes provenant d'un état, 8 sous-ensembles $S_{i,j}$, i= 0, 2, 4, 6, 8, 10, 12, 14 et j quelconque.

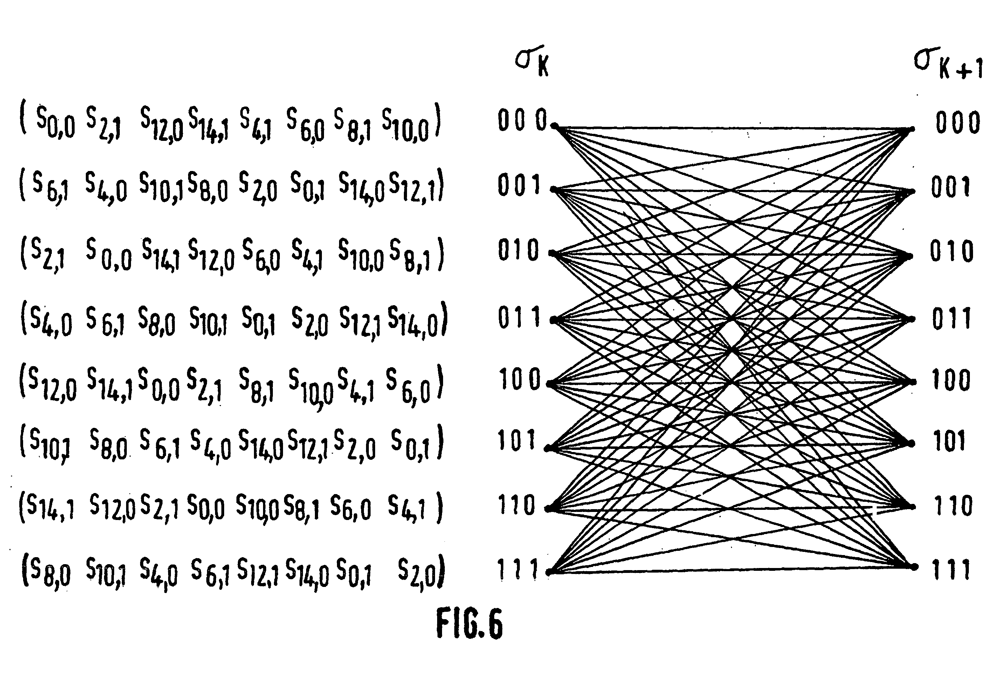

La figure 6 donne le treillis du code convolutif systématique 7/8 optimal. Dans cette figure $\sigma_k$ est l'état du codeur à l'instant k et $\sigma_{k+1}$ est état du codeur à l'instant k+1, l'état étant défini par les 3 bits en mémoire du codeur (3 registres à décalage). Cette figure donne aussi l'affectation des sous-ensembles $S_{i,j}$ aux différentes transitions du treillis. Le treillis s'analyse de la façon suivante.

A partir de l'état $\sigma(k)$ à l'instant kT:

$\sigma_k = (\sigma_k^2, \sigma_k^1, \sigma_k^0)$, le codeur va transiter vers un autre état $\sigma(k+1)$ à un instant $(k+1)T$: $\sigma_{k+1} = (\sigma_{k+1}^2, \sigma_{k+1}^1, \sigma_{k+1}^0)$

Ainsi de l'état [111] le codeur peut transiter vers un des 8 états [000] [001] [010] [011] [100] [101] [110] [111].

On observe par exemple que la 3-ème transition provenant de l'état 001, c'est-à-dire la transition 001 - 010, correspond à $S_{10,1}$. L'ensemble du treillis s'analyse de la même manière.

La figure 7 donne le schéma bloc du codeur 122 de rendement 7/8 (figure 3). Les 14 bits à l'entrée du codeur à l'instant k, $(i_1(k), j_1(k)$, 1= 1...7, sélectionnent les 7 premiers symboles du bloc transmis $U_1(k),...U_7(k)$ d'après la figure 8. Pour calculer le symbole de redondance $U_8(k)$, soit $(i_8(k), j_8(k))$, on calcule tout d'abord l'indice i (i pair) du sous-ensemble $S_i$ correspondant ou d'une façon équivalente les 3 bits $Y_3(k)$, $Y_2(k)$, $Y_1(k)$ avec $i = 8Y_3 + 4Y_2 + 2Y_1 + Y_0$, $Y_0$ = 0. On calcule aussi $i_8(k)$ soit le bit de parité des bits $i_1(k)$, ... $i_7(k)$. Le bit $j_8(k)$ est le bit de redondance d'un codeur convolutif systématique 230 de rendement 3/4 ayant pour entrées les bits $Y_1$, $Y_2$, et $Y_3$. Les bits $(i_8, j_8)$ sélectionnent le symbole $U_8(k)$. En sortie du code 3/4, on a l'état suivant du codeur $\sigma_{k+1}$ qui va servir à la fermeture du treillis à la fin d'une ligne ou d'une colonne (k = N).

Le calcul des bits $Y_1(k)$, $Y_2(k)$, $Y_3(k)$ et $i_8(k)$ en fonction des bits $i_1(k)$, $i_2(k)$, ... $i_7(k)$ est donné par les équations suivantes:

$$Y_1(k) = i_1(k) \oplus i_2(k) \oplus i_3(k) \oplus i_4(k)$$

$$Y_2(k) = i_1(k) \oplus i_2(k) \oplus i_5(k) \oplus i_6(k)$$

$$Y_3(k) = i_1(k) \oplus i_3(k) \oplus i_5(k) \oplus i_7(k)$$

$$i_8(k) = i_1(k) \oplus i_2(k) \oplus i_3(k) \oplus i_4(k) \oplus i_5(k) \oplus i_6(k) \oplus i_7(k)$$

Ces équations sont déduites de l'affectation binaire des sous-ensembles $S_i$ aux bits $Y_0$, $Y_1$, $Y_2$, et $Y_3$ (figure 5) qui est réalisée dans l'organe 210.

Cette structure du codeur (figure 7) permet d'affecter tous les blocs 8-D de $S_{i,j8}$ avec $i = 8Y_3 + 4Y_2 + 2Y_1$ aux transitions parallèles du treillis d'un état $\sigma$ vers un autre état.

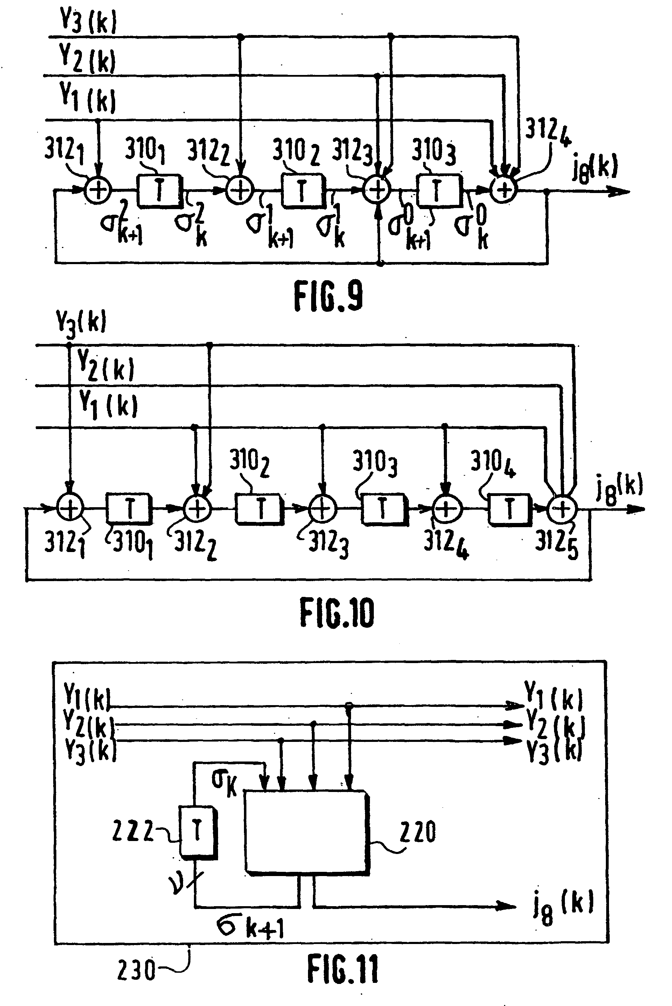

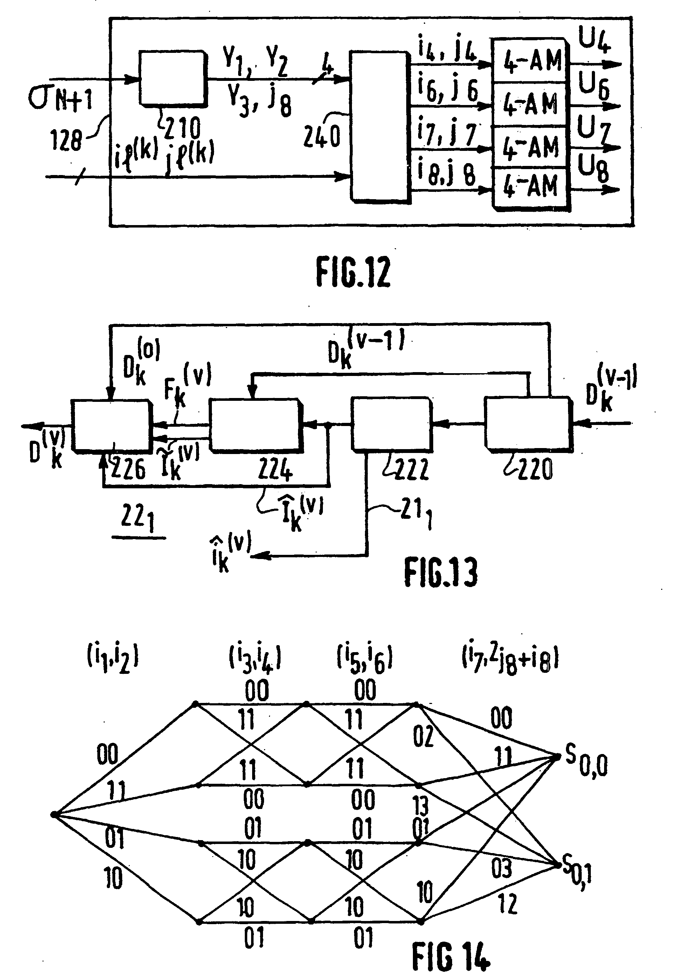

Le codeur convolutif de la figure 7 peut-être réalisé soit par une table (figure 11). soit par des registres à décalage (figures 9 et 10) soit par programmation d'un calculateur.

Sur la figure 11 la table 220 (mémoire) donne le bit de redondance $j_8(k)$ ainsi que l'état futur $\sigma_{k+1}$($\nu$ bits pour un code à $2^\nu$ états), en fonction de $\sigma_k$, $Y_1(k)$, $Y_2(k)$, $Y_3(k)$. La table 220 reçoit $Y_1$, $Y_2$, $Y_3$ ainsi que sa sortie $\sigma_{k+1}$ qui est rebouclée en entrée à travers une cellule de retard 222.

Les figures 9 et 10 donnent les schémas des codes optimaux à 8 états ($\nu$= 3) et à 16 états ($\nu$= 4). Pour un code à 8 états, on dispose d'une chaîne formée d'une cellule d'addition $312_1$, d'une cellule de retard $310_1$, d'une cellule d'addition $312_2$, d'une cellule de retard $310_3$, d'une cellule d'addition $312_3$, d'une cellule de retard $310_3$, d'une cellule d'addition $312_4$, la sortie de la chaîne délivrant $j_8(k)$.

La cellule d'addition $312_1$ reçoit $Y_1(k)$,

la cellule d'addition $312_2$ reçoit $Y_3(k)$,

la cellule d'addition $312_3$ reçoit $Y_2(k)$ et $Y_3(k)$,

la cellule d'addition $312_4$ reçoit $Y_1(k)$, $Y_2(k)$ et $Y_3(k)$,

Pour un code à 16 états (figure 10), on dispose d'une chaîne formée des mêmes éléments que pour la chaîne à 8 états avec en plus une cellule de retard $310_4$ et une cellule d'addition $312_5$.

La figure 12 concerne le dispositif de fermeture du treillis. Considérons l'état $\sigma$ du codeur et les sous-ensembles $S_{i,j8}$ (sous-ensembles 8-D) affectés à la transition ($2^{11}$ branches parallèles) qui ferme le treillis.

$$i = 8Y_3 + 4Y_2 + 2Y_1$$

Comme il y a $2^{11}$ branches qui permettent de fermer le treillis, on va choisir la branche en fonction des 4 symboles d'information $U_1$, $U_2$, $U_3$ et $U_5$, c'est-à-dire les 8 bits d'information $i_1$, $j_1$, $i_2$, $j_2$, $i_3$, $j_3$, $i_5$ et $j_5$.

-   Durant la transition de fermeture du treillis, on transmet 4 symboles d'information $U_1$, $U_2$, $U_3$ et $U_5$ correspondant aux bits $(i_1, j_1)$, $(i_2, j_2)$, $(i_3, j_3)$ et $(i_5, j_5)$ respectivement.

Le calcul est fait en 2 étapes (figure 12):

A partir de l'état $\sigma_{N+1}$ du codeur à la fin du codage d'une ligne ou d'une colonne, on génère les bits $Y_1(N+1)$, $Y_2(N+1)$, $Y_3(N+1)$ et $j_8(N+1)$ à partir de la table 210 contenant le tableau III.

Tableau III

| σ(binaire) ($\sigma^2$, $\sigma^1$, $\sigma^0$) | σ (décimal) | $S_{i,j8}$ | $Y_3 Y_2 Y_1$ | $j_8$ |
|---|---|---|---|---|
| 0 0 0 | 0 | $S_{0,0}$ | 0 0 0 | 0 |
| 0 0 1 | 1 | $S_{6,1}$ | 0 1 1 | 1 |
| 0 1 0 | 2 | $S_{2,1}$ | 0 0 1 | 1 |
| 0 1 1 | 3 | $S_{4,0}$ | 0 1 0 | 0 |
| 1 0 0 | 4 | $S_{12,0}$ | 1 1 0 | 0 |
| 1 0 1 | 5 | $S_{10,1}$ | 1 0 1 | 1 |
| 1 1 0 | 6 | $S_{14,1}$ | 1 1 1 | 1 |
| 1 1 1 | 7 | $S_{8,0}$ | 1 0 0 | 0 |

A partir des bits $Y_1(N+1)$, $Y_2(N+1)$, $Y_3(N+1)$ et $j_8(N+1)$, on calcule les bits $(i_4, j_4)$, $(i_6, j_6)$, $(i_7, j_7)$ et $(i_8, j_8)$ $(N+1)$ permettant de générer les symboles $U_4(N+1)$, $U_6(N+1)$, $U_7(N+1)$ et $U_8(N+1)$ dans des moyens de calculs 240. Ces bits sont calculés par:

$$i_4\,(N+1) = i_1\,(N+1) \oplus i_2\,(N+1) \oplus i_3\,(N+1) \oplus Y_1\,(N+1)$$

$$i_6\,(N+1) = i_1\,(N+1) \oplus i_2\,(N+1) \oplus i_5\,(N+1) \oplus Y_2\,(N+1)$$

$$i_7\,(N+1) = i_1\,(N+1) \oplus i_3\,(N+1) \oplus i_5\,(N+1) \oplus Y_3\,(N+1)$$

$$i_8\,(N+1) = i_2\,(N+1) \oplus i_3\,(N+1) \oplus i_5\,(N+1)\ Y_1\,(N+1)\ Y_2\,(N+1) \oplus Y_3\,(N+1)$$

Les bits $j_4$ et $j_6$ peuvent prendre n'importe quelle valeur. On les fixe par exemple à 0, $(j_4 = j_6 = 0)$.

Le bit $j_7$ est le bit de parité de tous les bits $(j_1,... j_7)$ des transitions précédentes:

$$j_7\,(N+1)\ =\ \sum_{k=1}^{N}\ \sum_{l=1}^{7}\ j_l(k)\ \oplus\ \sum_{l=1}^{6}\ j_l(N+1)$$

Ceci est effectué dans des moyens de calcul représentés sur la figure 12. Préférentiellement, les calculs sont réalisés par programmation d'un calculateur.

Les moyens de décodage sont représentés sur la figure 1. Le décodage est effectué par étapes dans deux étages différents. Dans le premier étage, on effectue un décodage itératif des bits les moins significatifs (LSB) des symboles émis (bits i).

On stocke dans une mémoire 20, la matrice des symboles reçus après le canal et correspondant à la matrice des symboles émis (la dimension de la matrice est la même que celle de la matrice codée à l'émission).

On décode successivement les lignes, puis les colonnes indépendamment. A chaque itération, on génère la décision (connexion $21_1$) sur les bits i (matrice des bits) et une matrice de symboles réels (fiabilité de la décision) qui sera utilisée pendant l'itération suivante est stockée dans la mémoire 20 (connexion $23_1$). Un désentrelaceur $24_1$ retarde les données.

- Pour le décodage d'une ligne ou d'une colonne, on utilise un décodeur de Viterbi $22_1$ à décisions souples, correspondant au code convolutif 7/8 à 8-D pour l'exemple concerné.

Dans le second étage, après un certain nombre d'itérations pour la 1ère étape (3 ou 4 en général), on passe (connexion 25) à l'étape 2 pour décoder les bits j , c'est-à-dire les bits les plus significatifs (MSB) des symboles émis.

On effectue le décodage itératif des lignes puis des colonnes en utilisant la matrice de symboles réels stockés en mémoire 20 ainsi que la matrice des bits i détectés par le 1er étage.

- Le décodeur $22_2$ d'une ligne ou d'une colonne est un décodeur à décisions souples du code de parité utilisé lors de la fermeture du treillis du code convolutif 7/8 pour chaque ligne et colonne du code produit.

Premièrement, considérons le fonctionnement du premier étage (voie 1). La figure 13 représente le schéma général d'un étage des moyens $22_1$ de décodage de Viterbi à double décision des bits LSB des symboles 4-AM émis (bits i). Ils comprennent:

- un sous-ensemble 220 de calcul des métriques,
- un décodeur de Viterbi 222 proprement dit qui délivre des décisions dures,
- un sous-ensemble 224 de calcul de fiabilité des décisions,
- un sous-ensemble 226 de calcul de décisions douces.

Le décodage de codes convolutifs systématiques va consister à appliquer un algorithme de décodage à décision douce. Pour simplifier l'exposé, on prendra pour exemple le code convolutif systématique de rendement 7/8. Selon l'exemple particulier décrit pour la ligne d'indice 1 du tableau I, une rangée du code produit est formée par les symboles suivants qui ont été émis à l'émission (pour simplifier l'écriture, l'indice de ligne, ici i=1, est omis dans ce qui suit):

- 7N+4 symboles d'information :

$$I= I_1, ..., I_{7N+4}$$

- N symboles de redondance de code:

$$R= R_1, ..., R_N$$

- 4 symboles de fermeture de treillis:

$$TR= TR_1, TR_2, TR_3, TR_4.$$

A cause des imperfections du canal de transmission, les symboles reçus $D^{(0)}=(D_1^{(0)}, ... , D_{8N+8}^{(0)})$ vont présenter des différences par rapport aux symboles émis.

A la réception, on reçoit des symboles complexes correspondant aux symboles MAQ 16 émis après passage dans le canal. Chaque symbole complexe étant considéré comme la suite de 2 symboles réels. Ensuite, on stocke ces symboles réels dans la mémoire 20 (figure 1) suivant une matrice ayant la même structure que la matrice définie à l'émission. Les symboles réels reçus sont rangés dans la matrice en respectant le même ordre que celui utilisé à l'émission. Le processus de décodage des bits i est itératif, c'est-à-dire que l'on décode les lignes de la matrice puis les colonnes. Le nombre de lignes ou de colonnes à décoder à chaque itération est égal à 7N+4. dans le cas du tableau I (cas sans codage de la redondance) ou à 8N+8 dans le cas où la redondance est codée. (Tableau II).

Tout d'abord, considérons le décodage itératif à la v-ème itération pour une ligne de la matrice c'est-à-dire un bloc de symboles réels: $D^{(v-1)} = (D_1^{(v-1)}, ....., D_{8N+8}^{(v-1)}$ . L'indice v est un entier correspondant au numéro de l'itération. Le décodage fournit le bloc: $D^{(v)}=(D_1^{(v)}, ..., D_{8N+8}^{(v)}$ de 8N+8 symboles réels (sortie douce) qui seront appliqués à l'itération suivante ainsi que la décision optimale des bits $\hat{i}^{(v)}=(\hat{i}_1^{(v)},..., \hat{i}_{8N+8}^{(v)}$ correspondant aux bits émis $i=(i_1, ..., i_{8N+8})$ qui sont les bits du premier niveau de partition (bits LSB) des symboles 4-AM émis $(I_1, ... I_{7N+4}, R_1, ... R_N, TR_1, ... TR_4)$ respectivement. On suppose que les 7N+4 symboles $D_1^{(v-1)}, ..., D_{7N+4}^{(v-1)}$ correspondent aux symboles d'information, et les N symboles $D_{7N+5}^{(v-1)},...,D_{8N+4}^{(v-1)}$ correspondent aux symboles de redondance du code 7/8 et les 4 symboles $D_{8N+5}^{(v-1)}, ..., D_{8N+8}^{(v-1)}$ sont les symboles redondants de fermeture du treillis. Les symboles sont traités dans l'ordre suivant:

$$D_1^{(v-1)}, .. D_7^{(v-1)}, D_{7N+5}^{v-1};$$

$$D_8^{(v-1)}, .. D_{14}^{(v-1)}, D_{7N+6}^{(v-1)};$$

......

$$D_{7N-6}^{(v-1)}, .. D_{7N}^{(v-1)}, D_{8N+4}^{(v-1)};$$

$$D_{7N+1}^{(v-1)}, ... D_{7N+}^{(v-1)}4, D_{8N+5}^{(v-1)};...D_{(8N+8}^{v-1}.$$

Le décodage est effectué en six étapes. L'exposé suivant indique la manière de déduire $D^{(v)}$ de $D^{(v-1)}$.

La première étape concerne le calcul des métriques. Le sous-ensemble 220 de calcul des métriques (Figure 13) réalise pour chaque bloc de 8 symboles (1-ème bloc, 1=0,...N-1)

$$\left(D_{7\,1+1}^{(v-1)}, ---D_{7\,1+7}^{(v-1)}, D_{7N+5+1}^{(v-1)}\right)$$

la détection et le calcul de métriques dans chaque sous-ensemble 8-D $S_{i,j}$, ainsi que pour le bloc

$$\left(D_{7N+1}^{(v-1)}, ---D_{7N+4}^{(v-1)}, D_{8N+5}^{(v-1)}, ....D_{8N+8}^{(v-1)}\right)$$

correspondant à la transition fermant le treillis à la fin du codage d'une ligne ou d'une colonne du code produit. Pour simplifier, on note par $(r_1,---r_8)$ le bloc 8-D. Le calcul des métriques est effectué en plusieurs étapes.

Tout d'abord considérons le calcul des métriques dans la constellation 1-D. Pour k=1,... 7 (7 premiers symboles du bloc), on détecte le symbole 4-AM le plus proche dans chacun des sous-ensembles $B_0 = \{3, -1\}$ et $B_1 = \{1,-3\}$ et on calcule la métrique correspondante : $M_{k,0}$ et $M_{k,1}$ respectivement, où $M_{k,i}$ est égal au carré de la distance Euclidienne entre $r_k$ et le symbole le plus proche dans $B_i$.

Pour k=8, on calcule les métriques $M_{8,0}$, $M_{8,1}$, $M_{8,2}$ et $M_{8,3}$ du symbole $r_8$ dans chaque sous-ensemble $C_i$, i =0, 1, 2, 3 respectivement, où $C_i$ contient le point 4-AM correspondant à la valeur i en décimale des 2 bits affectés à la constellation 4-AM.

Ensuite on calcule les métriques dans la constellation 2-D. Pour les 3 premiers blocs 2-D (couples de symboles), c'est-à-dire $(r_1, r_2)$ $(r_3, r_4)$ et $(r_5, r_6)$, on fait la détection et on calcule les métriques $M_{k,l}^{(2)}$ pour k =1, 3, 5 dans les 4 sous-ensembles 2-D $E_l^{(2)} = B_i B_{i'}$ avec l= 2i + i', i = 0, 1 et i'= 0, 1.

La métrique 2-D est définie comme étant la somme des 2 métriques 1-D des 2 symboles du bloc 2-D. On obtient la métrique de $(r_k, r_{k+1})$ dans $E_l^{(2)}$, pour k = 1, 3, 5 :

$$M_{k,l}^{(2)} = M_{k,i} + M_{k+1,i'} \text{ pour } l = 0, 1, 2, 3$$

avec l = 2i + i'.

Pour le dernier bloc 2-D $r_7, r_8$, on calcule les métriques $M_{7,l,j}^{(2)}$ dans les 8 sous-ensembles 2-D $E_{l,j}^{(2)} = B_i C_{2j+i'}$ pour i = 0, 1, i' = 0, 1, j = 0, 1 avec 1 = 2i + i' :

$$M_{7,l,j}^{(2)} = M_{7,i} + M_{8,2j+i'}$$

Puis on calcule les métriques dans la constellation 4-D. On détecte et on calcule les métriques $M_{1,l}^{(4)}$ du bloc 4-D $(r_1 r_2 r_3 r_4)$ dans les 8 sous-ensembles à quatre dimensions $E_l^{(4)}$, avec l = 0, 1,...7:

$$E_0^{(4)} = E_0^{(2)} E_0^{(2)} \cup E_3^{(2)} E_3^{(2)}$$

$$E_1^{(4)} = E_0^{(2)}\, E_1^{(2)} \cup E_3^{(2)}\, E_2^{(2)}$$

$$E_2^{(4)} = E_0^{(2)}\, E_2^{(2)} \cup E_3^{(2)}\, E_1^{(2)}$$

$$E_3^{(4)} = E_0^{(2)}\, E_3^{(2)} \cup E_3^{(2)}\, E_0^{(2)}$$

$$E_4^{(4)} = E_1^{(2)}\, E_0^{(2)} \cup E_2^{(2)}\, E_3^{(2)}$$

$$E_5^{(4)} = E_1^{(2)}\, E_1^{(2)} \cup E_2^{(2)}\, E_2^{(2)}$$

$$E_6^{(4)} = E_1^{(2)}\, E_2^{(2)} \cup E_2^{(2)}\, E_1^{(2)}$$

$$E_7^{(4)} = E_1^{(2)}\, E_3^{(2)} \cup E_2^{(2)}\, E_0^{(2)}$$

Pour chaque sous-ensemble, on calcule 2 métriques 4-D et on prend la métrique minimale. Par exemple, pour $E_0^{(4)}$ on calcule:

-  la métrique $M_{1,0}^{(2)} + M_{3,0}^{(2)}$ dans $E_1^{(2)} E_0^{(2)}$;
-  la métrique dans $M_{1,3}^{(2)} + M_{3,3}^{(2)}$ dans $E_1^{(2)} E_3^{(2)}$;
-  la métrique dans $M_{1,0}^{(4)} E_0^{(4)}$ de $(r_1\ r_2\ r_3\ r_4)$, égale à: $\min [M_{1,0}^{(2)} + M_{3,0}^{(2)}, M_{1,3}^{(2)} + M_{3,3}^{(2)}]$.

Pour le bloc $(r_5\ r_6\ r_7\ r_8)$, on détecte et on calcule les métriques $M_{5,l,j}^{(4)}$ dans les sous-ensembles $E_{l,j}^{(4)}$ pour l=0,1,...7 et j=0,1. Les sous-ensembles $E_{l,j}^{(4)}$ sont définis de la même façon que $E_l^{(4)}$ sauf que le dernier symbole est positif pour j=0 et qu'il est négatif pour j=1. Par exemple $E_{0,j}^{(4)} = E_0^{(2)} E_{0,j}^{(2)} \cup E_3^{(2)} E_{3,j}^{(2)}$. Donc il suffit de remplacer l'indice k du deuxième sous-ensemble 2-D par k,j. La métrique dans $E_{0,j}^{(4)}$ est:

$$M_{5,0j}^{(4)} = \min[M_{5,0}^{(2)} + M_{7,0,j}^{(2)}, M_{5,3}^{(2)} + M_{7,3,j}^{(2)}].$$

Enfin on calcule les métriques dans les 16 sous-ensembles 8-D. Le sous-ensemble $S_{i,j}$ pour i pair est l'union des 4 sous-ensembles 8-D, chacun étant la concaténation de 2 sous-ensembles 4-D:

$$S_{i,j} = \cup\ E_l^{(4)}\ E_{l,j}^{(4)} \text{ avec } i_2\text{=0,1 et } i_3\text{=0,1}$$

et:

$$i = 8Y_3 + 4Y_2 + 2Y_1;$$

$$l = 4i_2 + 2i_3 + i_4;$$

$$l' = 4i_6 + 2i_7 + i_8;$$

$$i_4 = i_2 \oplus i_3 \oplus Y_1$$

$$i_6 = i_2 \oplus Y_2$$

$$i_7 = i_3 \oplus Y_3$$

$$i_8 = i_2 \oplus i_3 \oplus i_4 \oplus i_6 \oplus i_7.$$

Le calcul de la métrique de $r_1...r_8$ dans $S_{i,j}$ nécessite le calcul de métriques dans les 4 sous-ensembles 8-D $E_l^{(4)}$ $E_{l,j}^{(4)}$ (Somme de la métrique de ($r_1$ $r_2$ $r_3$ $r_4$) dans $E_l^{(4)}$ et celle de ($r_5$ $r_6$ $r_7$ $r_8$) dans $E_{l,j}^{(4)}$). Le minimum de ces 4 métriques donne la métrique 8-D dans $S_{i,j}$, $M_{i,j}^{(8)}$.

Pour chaque bloc 8-D, on fait la détection et on calcule les métriques dans chaque sous-ensemble $S_{i,j}$ qui seront fournies au décodeur de Viterbi. Ces métriques sont aussi les métriques des branches du treillis pendant les transitions 1, 2,..., N+1.

Toujours dans le premier étage, on effectue la deuxième étape du décodage. Le sous-ensemble 222 réalise un décodage conventionnel de Viterbi sur les séquences de symboles reçus. On obtient ainsi la séquence optimale décodée (décision dure) de la ligne:

$\hat{I}^{(v)} = \hat{I}_1^{(v)}, ... \hat{I}_{7N+4}^{(v)}, \hat{I}_{7N+5}^{(v)}, ... \hat{I}_{8N+8}^{(v)}$ ainsi que la séquence des bits LSB décodés:
$\hat{i}^{(v)} = \hat{i}_1^{(v)}, ... \hat{i}_{8N+8}^{(v)}$ et la séquence des sous-ensembles 8-D correspondants.

La séquence des états correspondants aux états décodés est:

$\hat{\sigma}^{(i)} = \hat{\sigma}_0^{(i)}, ... \hat{\sigma}_{N+1}^{(i)}$ ce qui correspond à N+1 transitions ou branches, avec $\hat{\sigma}_0^{(i)}, = \hat{\sigma}_{N+1}^{(i)} = 0$, état initial et état final nuls. On mémorise le vecteur de la métrique d'état $M_j^{(i)}(\sigma)$ pour chaque état $\sigma = 0,...7$ et pour chaque instant j= 1,...N+1. Finalement on stocke les chemins survivants dans une table. Toutes ces résultats délivrés par le décodeur de Viterbi 222 sont utilisés pour le calcul de la fiabilité.

Durant la troisième étape, on calcule la fiabilité de chaque symbole $\hat{I}_k^{(v)}$ ou de chaque bit $\hat{i}_k^{(v)}$ de la séquence décodée $\hat{I}^{(v)}$ avec k=1, ... 8N+8 dans le sous-ensemble 224. La fiabilité caractérise la qualité des symboles décodés (probabilité d'exactitude). Cette fiabilité peut s'écrire:

$$F^{(i)} = F_1^{(i)}, ... F_{8N+8}^{(i)}.$$

La fiabilité d'un symbole d'ordre k s'écrit:

$$F_k^{(v)} = \log\left[\frac{\left(\sum_{C(\hat{I}^{(v)})} Prob(D^{(v-1)}|C)\right)}{Prob(D^{(v-1)}|\hat{I}^{(v)})}\right]$$

où $D^{(v-1)}$ est la séquence de symboles d'entrée et où $C(\hat{I}_k^{(v)})$ est le jeu de mots-codes correspondant à un symbole 4-AM adjacent à $\hat{I}_k^{(v)}$. La fiabilité $F_k^{(v)}$ peut s'écrire:

$$F_k^{(v)} = \log\left[\sum_{C(\hat{I}_k^{(v)})} \exp\frac{d^2(D^{(v-1)}, \hat{I}^{(v)}) - d^2(D^{(v-1)}, C)}{N_0}\right].$$

En prenant le terme principal de la somme, on peut écrire:

$$F_k^{(v)} \simeq \min_{C(\hat{I}_k^{(v)})}[d^2(C, D^{(v-1)}) - d^2(\hat{I}^{(v)}, D^{(v-1)})].$$

Ce minimum correspond au plus proche chemin d'erreur fournissant un symbole 4-AM décodé adjacent au symbole $\hat{I}_k^{(v)}$. Cette définition de la fiabilité est aussi celle des bits $\hat{i}_k^{(v)}$. En effet, un symbole adjacent à $\hat{I}_k^{(v)}$ correspond

à un bit i qui est le complément de $\hat{i}^{(v)}$.

Le calcul de la fiabilité s'opère selon l'algorithme suivant.

La séquence décodée par le décodeur de Viterbi $\hat{i}^{(v)}$ correspond à un chemin dans le treillis de longueur N+1. L'algorithme de calcul de la fiabilité $F^{(v)}_k$ de la décision $\hat{i}^{(v)}_k$ pour k=1,...8N+8 est le suivant:

La fiabilité de la décision $\hat{i}^{(v)}_k$ pour k = 1,---8N+8 ou du bit $\hat{i}^{(v)}_k$ pour k = 1,---8N+8 est effectuée en 2 étapes. La première consiste à calculer la fiabilité par rapport aux chemins d'erreurs correspondants aux transitions parallèles et la deuxième consiste à calculer la fiabilité par rapport aux chemins d'erreurs du treillis. La fiabilité finale est le minimum des deux.

On calcule d'abord la fiabilité FP due aux branches parallèles. Le traitement est effectué bloc par bloc sur la séquence des symboles $D^{(v-l)}$ et $\hat{i}^{(v)}$. Chaque traitement permet de calculer les fiabilités dues aux branches parallèles des 8 symboles ($D^{(v-l)}_1$, ---, $D^{(v-l)}_7$, $D^{(v-l)}_8$) correspondant à la 1-ème transition (I = 0, ..., N-1) et les 8 symboles ($D^{(v-l)}_{7N+1}$, ..., $D^{(v-l)}_{7N+4}$, $D^{(v-l)}_{8N+8}$) correspondant à la (N+1)-ème transition (celle qui ferme le treillis). Comme les branches parallèles du treillis sont affectées aux sous-ensembles 8-D $S_{i,j}$, cette fiabilité est aussi la fiabilité de la décision $\hat{i}^{(v)}_k$ dans le sous-ensemble 8-D contenant le bloc décodé correspondant à $\hat{i}^{(v)}_k$ (la séquence des sous-ensembles 8-D décodés est fournie par le décodeur de Viterbi).

$S_i$ ($r_1, ... r_8$) est le bloc ($D^{(v-l)}_1$, ..., $D^{(v-l)}_7$, $D^{(v-l)}$) par exemple et $S_{i,j}$ le sous-ensemble 8-D décodé correspondant aux symboles 4-AM détectés ($d_1, ... d_8$) = ($\hat{i}^{(v)}_{7N+5}$, ..., $\hat{i}^{(v)}_7$, $\hat{i}^{(v)}$), on peut montrer que le calcul des fiabilités de $r_k$ (pour k = 1,...8) dans $S_{i,j}$ revient à calculer les fiabilités de ($r_1, r_2, r_3, (1-2Y_1)r_4, r_5, (1-2Y_2)r_6, (1-2Y_3)r_7, (1-2(Y_1 \oplus Y_2 \oplus Y_3))$ $r_8$) dans le sous-ensemble $S_{o,j'}$, avec $j' = j \oplus Y_1 \oplus Y_2 \oplus Y_3$, et i = $8Y_3 + 4Y_2 + 2Y_1$. Ainsi on se ramène dans tous les cas à calculer les fiabilités dans $S_{0,0}$ ou $S_{0,1}$, ce qui rend l'algorithme plus simple.

La figure 14 donne une représentation en treillis des sous-ensembles $S_{0,0}$ et $S_{0,1}$ où chaque chemin dans le treillis correspond à un sous-ensemble de la forme $B_{i1} B_{i2} ... B_{i7} C_{2j8+i8}$,

Nous allons décrire l'algorithme pour $S_{0,0}$, c'est-à-dire $S_{i,j} = S_{0,0}$, afin de calculer les fiabilités des décisions $d_k$ pour k = 1, ... 8:

On réalise tout d'abord le calcul des métriques 2-D :

$$M_{i,j}(1) = M_{1,i} + M_{2,j} \quad i = 0,1 \; ; \; j = 0,1$$

$$M_{i,j}(2) = M_{3,i} + M_{4,j} \quad i = 0,1 \; ; \; j = 0,1$$

$$M_{i,j}(3) = M_{5,i} + M_{6,j} \quad i = 0,1 \; ; \; j = 0,1$$

$$M_{i,j}(4) \; M_{7,i} + M_{8,j} \quad i = 0,1 \; ; \; j = 0,1$$

où

$M_{k,i}$ est la métrique de $r_k$ dans $B_i$ pour k = 1,...7; et

$M_{8,i}$ est la métrique de $r_8$ dans $C_i$.

Dans le cas où le calcul des fiabilités est effectué pour $S_{0,1}$, $M_{8,i}$ est calculé dans $C_2$ et $C_3$ (i = 2, 3).

- On opère alors une recherche du chemin le plus proche de ($r_1, ... r_8$) dans $S_{0,0}$ :

On considère séparément la partie supérieure et la partie inférieure du treillis de $S_{0,0}$. Dans le treillis supérieur on calcule M(0,k) = min ($M_{0,0}(k)$, $M_{1,1}(k)$) pour k = 1, 2, 3

$$M(0,4) = \min (M_{0,0}(4), M_{1,1}(4)).$$

On stocke les bits ($i_1,...i_8$) donnant le minimum, avec $i_1 = i_2$, $i_3 = i_4$, $i_5 = i_6$, $i_7 = i_8$, dans la table [i(0,1), ... i(0,8)] et on calcule :

$$MET(0) = \sum_{k=1}^{4} M(0,k)$$

Dans le treillis inférieur on calcule M(1,k) = min (M$_{0,1}$(k), M$_{1,0}$(k)) pour k = 1, 2, 3,

M (1,4) = min (M$_{0,1}$(4), M$_{1,0}$(4)).

$$MET\ (1)\ =\ \sum_{k=1}^{4}\ M(1,k)$$

On stocke les bits i$_1$...i$_8$ correspondant au minimum dans [i(1,1),---i(1,8)] avec $i_1=\overline{i}_2$, $i_3=\overline{i}_4$, $i_5=\overline{i}_6$, $i_7=\overline{i}_8$.

On vérifie si les séquences [i(0,1),...i(0,8)] et [i(1,1),...i(1,8)] sont 2 séquences valides. On calcule les bits de parité p(0) et p(1) pour les séquences [i(0,1), i(0,3), i(0,5), i(0,7)] et [i(1,1), i(1,3), i(1,5), i(1,7)] respectivement. Pour k = 0, 1, si p(k) = 0, la séquence correspondante appartient au treillis (ou à S$_{0,0}$ ), sinon la séquence sera modifiée.

On calcule des différences de métriques 2-D :

$$\delta(0,k) = |\ M_{0,0}(k) - M_{1,1}(k)\ |, \ k = 1, 2, 3$$

$$\delta(0,k)\ |\ M_{0,0}(k) - M_{1,1}(k)\ |, \ k = 4$$

$$\delta(1,k) = |\ M_{0,1}(k) - M_{1,0}(k)\ |, \ k = 1, 2, 3$$

$$\delta(1,k) = |\ M_{0,1}(k) - M_{1,0}(k)\ |, \ k = 4$$

Puis on calcule le minimum des 4 métriques pour chacun des 2 treillis supérieurs et inférieurs (q = 0, 1 respectivement) :

$$\Delta\ (q)\ =\ \min_{k=1,---,4}\ \delta\ (q,k)\ ,\ q = 0,1$$

On stocke l'indice k donnant le minimum dans k$_{min}$(q) et on calcule le second minimum $\Delta_2$(q).

- Si le bit de parité p(q) = 1, on complémente les bits i(q, 2 k$_{min}$(q)-1), i(q, 2k$_{min}$(q)) et on incrémente la métrique MET(q) de $\Delta$(q) . Cette opération est faite pour q = O (treillis supérieur) et q = 1 (treillis inférieur).

Puis on calcule $\Delta_{min}$ = |*MET*(0) - *MET*(1) | et on mémorise l'indice c (0 ou 1) donnant le minimum de MET(0) et MET(1).

On initialise les fiabilités FP(1), ..., FP(8) de (d$_1$...d$_8$) dans S$_{0,0}$ :

$$FP(2k-1) = FP(2k) = \delta(c,k) + (1 - 2p(c))\ \Delta(c)\ pour\ K \neq K_{min}\ (c)$$

$$FP(2k-1) = FP(2k) = \Delta_2(c) + (1 - 2p(c))\ \Delta(c)\ pour\ k = k_{min}\ (c)$$

où FP(k) est la fiabilité de d$_k$ dans S$_{0,0}$.

Puis on met à jour les fiabilités FP(k), k = 1,...8 :

. Pour k = 1, ... 8 avec i(c,k) ≠ i (1-c, k) :

$$FP(k) = min\ [FP(k),\ \Delta_{min}]$$

. Pour k = 1, 2, 3, 4 :

$$FP(2k-1) = \min [FP(2k-1), A_k]$$

si $i(0, 2k-1) = i(1, 2k-1)$

$$FP(2k-1) = \min [FP(2k), A_k] \text{ si } i (0,2k) = i(1,2k)$$

avec

$$A_k = \Delta_{min} + \delta(1-c, k) + [1 - 2p(1-c)] \Delta (1-c) \text{ si } k \neq k_{min} (1-c)$$

$$A_k = \Delta_{min} + \Delta_2 (1-c) + [1 - 2p(1-c)] \Delta (1-c) \text{ si } k = k_{min} (1-c).$$

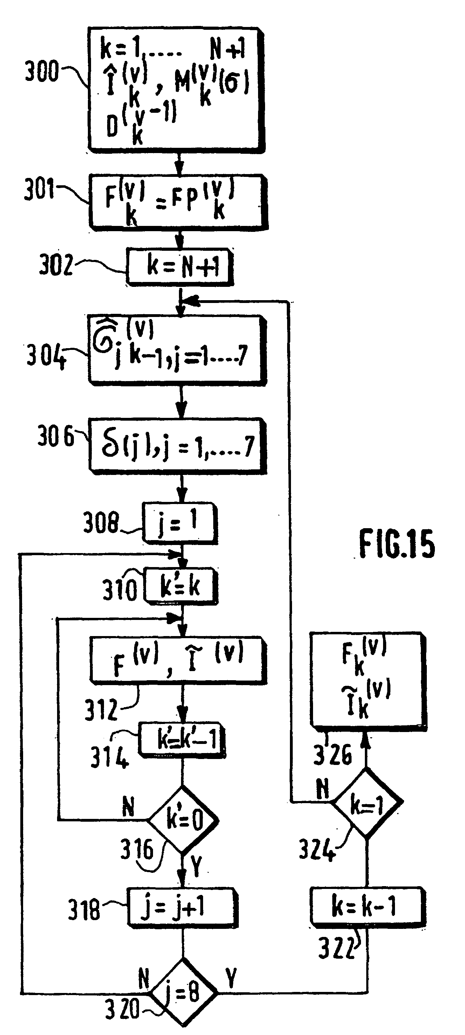

On détermine la fiabilité due aux chemins d'erreur du treillis (Figure 15). Considérons le décodage d'une ligne (étape 300).

On part de :

- $\hat{I}_k^{(v)}$ qui est la séquence de symboles 4-AM décodés par le décodeur de Viterbi pour k = 1,...8N+8;
- $M_k^{(v)} (\sigma)$ = qui est la métrique de l'état $\sigma$ à l'instant k (k-ème transition) pour k =1,...N+1.
- $D_k^{(k-1)}$ qui sont les symboles d'entrée (fournis par le décodeur à l'itération précédente) pour k = 1, ... 8N+8,

et on initialise le tableau des fiabilités $F^{(v)} = (F_k^{(v)}, k= 1,...8N+8)$ à $FP^{(v)} = (FP_k^{(v)}, k = 1,...8N+8)$ ou $FP_k^{(v)}$ est la fiabilité de $\hat{I}_k^{(v)}$ due aux transitions parallèles (étape 301 figure 15).

- pour k=N+1,...2 où k correspond à un instant (indice de la transition) on effectue les opérations suivantes:

a) à partir de l'état du codeur après la k-ième transition dans le chemin décodé $\hat{\sigma}_k^{(v)}$ on détermine l'état $\hat{\sigma}_k^{(v)}$ après la (k-1)-ième transition du chemin décodé et les 7 autres états précurseurs de $\hat{\sigma}_k^{(v)}$ c'est-à-dire $\sigma_{j,k-1}^{(v)}$, $j$=1...7 (étape 304). Pour cela, les valeurs de $\hat{\sigma}_k^{(v)}$ pour k variant de 1 à N+1, sont fournies par le décodeur de Viterbi tandis que les valeurs de $\sigma_{j,k-1}^{(v)}$ peuvent être stockées dans une mémoire.

A partir des métriques des états $\sigma_{1,k-1}^{(v)}, \sigma_{2,k-1}^{(v)}, ... \sigma_{7,k-1}^{(v)}$ et $\hat{\sigma}_k^{(v)}$ calculées et stockées dans le décodeur de Viterbi pour k = 2,... N+1, et qui sont notées:

$$M_{k-1}^{(v)} (\sigma_{1,k-1}^{(v)})$$

$$M_{k-1}^{(v)} (\sigma_{2,k-1}^{(v)})$$

$$.....$$

$$M_{k-1}^{(v)} (\sigma_{7,k-1}^{(v)})$$

$$M_k^{(v)} (\hat{\sigma}_k^{(v)})$$

on calcule les 7 métriques cumulées de l'état $\hat{\sigma}_k^{(v)}$ pour les 7 chemins provenant des 7 états $\sigma_{j,k-1}^{(v)}$, $j$=1, ...7. Ces 7 métriques cumulées sont : $\delta_k(j) = M_{k-1}^{(v)}(\sigma_{j,k-1}^{(v)} + MET^k(\sigma_{j,k-1}^{(v)} \rightarrow \hat{\sigma}_k^{(v)})$ où $MET (\sigma_{j,k-1}^{(v)} \rightarrow \hat{\sigma}_k^{(v)})$ est la métrique de la transition de l'état $\hat{\sigma}_{j,k-1}^{(v)}$ vers l'état $\hat{\sigma}_k^{(v)}$ qui est aussi la métrique du sous-ensemble 8-D affecté à cette transition. Ces métriques sont stockées dans une mémoire au cours du décodage de Viterbi (étape 306).

On calcule la différence entre la métrique optimale et chacune des métriques cumulées:

$$\Delta (j) = \delta(j) - M_k^{(v)} (\hat{\sigma}_k^{(v)}), j=1, \dots 7$$

où $M^{(v)}(\hat{\sigma}^{(v)})$ est la métrique optimale de l'état $\hat{\sigma}^{(v)}$.

Ensuite on examine les 7 survivants précurseurs à l'état $\hat{\sigma}^{(v)}$. On remonte au survivant d'ordre j de $\hat{\sigma}^{(v)}$ vers $\sigma_{j,k-1}^{(v)}$. Puis on examine chaque survivant d'ordre j de l'état $\sigma_{j,k-1}^{(v)}$ jusqu'à l'état initial σ=0 , ce qui consiste à faire varier l'indice de la transition de k à 1.

Pour réduire la complexité, on peut examiner les 7 survivants de l'état $\sigma^{(v)}$ jusqu'à l'état du survivant à l'instant k-L au lieu de l'instant 1, donc un nombre fixe de transitions. Pour L=3 la dégradation des performances est négligeable.

On compare les 8 symboles 4-AM affectés à la k'-ème transition du survivant d'ordre j aux 8 symboles décodés pour k' variant de k jusqu'à 1 ou de k à (k-L) dans le second cas. Si le symbole décodé et le symbole de la k'-ème transition du survivant j de même rang sont adjacents, on remplace la fiabilité du symbole décodé par Δ (j) si ce dernier est inférieur à cette fiabilité (étape 312).

On calcule la table des symboles $\tilde{I}_k^{(v)}$ adjacents à $\hat{I}_k^{(v)}$ correspondant au minimum, pour k variant de 1 à 8N+8, et, à chaque mise à jour de la fiabilité d'un symbole, on met à jour son symbole adjacent en le remplaçant par le symbole 4-AM correspondant relatif à la transition d'ordre k' du survivant j.

A la fin, on obtient les fiabilités $F_k^{(v)}$ du symbole décodé $\hat{I}_k^{(v)}$ ainsi que le symbole adjacent $\tilde{I}_k^{(v)}$ correspondant pour k=1, ... 8N+8 (étape 326).

La fiabilité est ensuite normalisée durant la quatrième étape pour permettre de calculer la décision douce $\tilde{D}_k^{(v)}$ pour k = 1,...8N+8, Trois méthodes sont utilisables pour calculer la fiabilité normalisée $F_k^{norm(v)}$. On peut calculer : soit

$$F_k^{norm(v)} = F_k^{(v)} / \bar{F}$$

soit

$$F_k^{norm(v)} = F_k^{(v)} + (1-\bar{F})$$

soit

$$F_k^{norm(v)} = (F_k^{(v)} / \beta_1 + \beta_2$$

où $\bar{F}$ est égale à la moyenne de $F_k^{(v)}$ calculée sur toute la matrice des fiabilités, $\beta_1$ et $\beta_2$ étant des constantes vérifiant

$$\bar{F} = \beta_1(1-\beta_2).$$

On calcule ensuite, au cours de la cinquième étape, des décisions douces non pondérées (sous-ensemble 226, figure 13).

La décision douce $\tilde{D}_k^{(v)}$ est calculée à partir de la décision optimale $\hat{I}^{(v)}$ fournie par le décodeur de Viterbi, de sa fiabilité normalisée $F^{norm(v)}$ et de la séquence des symboles 4-AM $\tilde{I}_k^{(v)}$ obtenue précédemment. Le symbole 4-AM $\tilde{I}_k^{(v)}$ est un symbole adjacent du symbole $\hat{I}^{(v)}$ c'est-à-dire que $|\hat{I}_k^{(v)} - \tilde{I}_k^{(v)}|$. Il correspond au symbole 4-AM le plus probable après le symbole $\hat{I}_k^{(v)}$. Le symbole $\tilde{D}_k^{(v)}$ est donné par:

$$\tilde{D}_k^{(v)} = 1/2\left(\hat{I}_k^{(v)} + \tilde{I}_k^{(v)}\right) + sgn\left(\hat{I}_k^{(v)} - \tilde{I}_k^{(v)}\right)F_k^{norm(v)}$$

où la fonction sgn est définie par :

$$sgn(x) = \begin{pmatrix} 1 & si & x>0 \\ 0 & si & x=0 \\ -1 & si & x<0 \end{pmatrix}$$

Ainsi le symbole $\tilde{D}_k^{(v)}$ correspond à un symbole situé à la distance $F^{norm(v)}$ du seuil de décision entre $\hat{l}_k^{(v)}$ et $\bar{l}_k^{(v)}$.. Comme $E(F^{norm(v)})= 1$, les symboles $\tilde{D}_k^{(v)}$ seront centrés autour des symboles 4-AM.

Pour améliorer les performances, au cours d'une sixième étape, on pondère $\tilde{D}_k^{(v)}$ avec les symboles $D_k^{(0)}$ reçus après le canal qui sont conservés dans la mémoire 20 pour calculer $D_k^{(v)}$ :

$$D_k^{(v)} = \alpha_v \, \tilde{D}_k^{(v)} + (1 - \alpha_v) \, D_k^{(0)}$$

où $\alpha_v$ est un coefficient de pondération. Par exemple: $\alpha_1 = 0{,}6$ ; $\alpha_2 = 0{,}9$ ; $\alpha_v = 1$ pour v supérieur à 2. Le but est de réduire l'effet de propagation d'erreurs durant les premières itérations. Les étapes 5 et 6 sont effectuées ensembles dans le sous-ensemble 226.

Deuxièmement, considérons le fonctionnement du second étage (voie 2) pour le décodage des bits j. Les bits j, donc les bits MSB des symboles 4-AM sont codés par le code de parité appliqué à chaque ligne et à chaque colonne de la matrice du code produit. Ceci est réalisé lors de la fermeture du treillis. Le décodage est un décodage itératif comme pour les bits i.

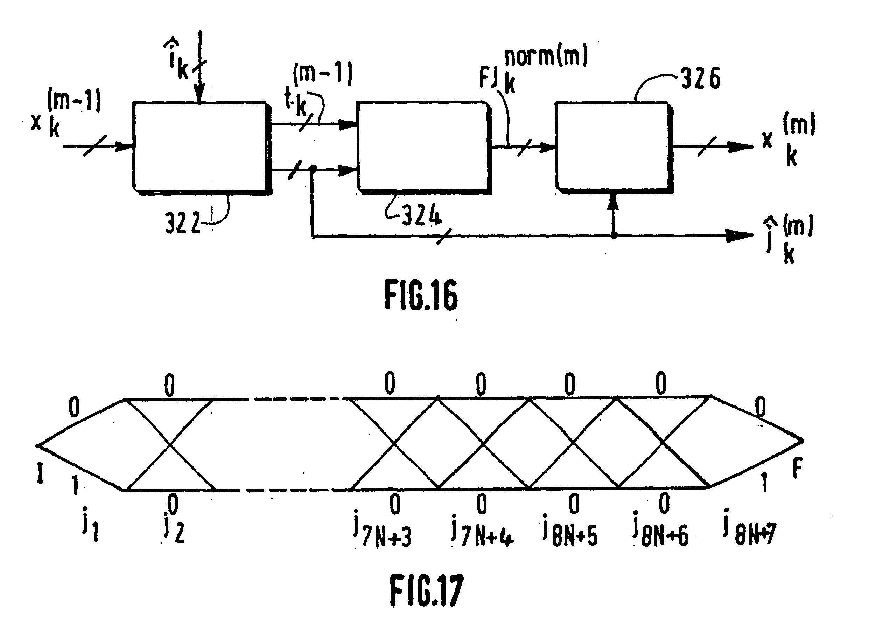

La figure 16 représente le schéma général d'un étage des moyens $22_1$ de décodage du code de parité des bits MSB des symboles 4-AM émis. Ils comprennent:

- un décodeur 322 de code de parité qui délivre des décisions dures;
- un sous-ensemble 324 de calcul de fiabilité des décisions;
- un sous-ensemble 326 de calcul des décisions douces.

Pour la première itération (m=1), les symboles $X_k^{(0)}$ sont les symboles reçus en sortie du canal c'est-à-dire :

$$(D_1^{(0)}, \, ... \, D_{7N+4}^{(0)}, \, D_{8N+5}^{(0)}, ... \, D_{8N+7}^{(0)}.$$

La figure 17 donne une représentation en treillis des 7N+7 bits $(j_1, \, ... \, j_{7N+4}, \, j_{8N+5}, \, j_{8N+6}, \, j_{8N+7})$ codés par le code de parité. Dans ce treillis, tout chemin du point I au point F correspond à un mot de code de longueur 7N+7. Le décodage d'un bloc de 7N+7 symboles $x_k^{(m-1)}$ pour l'itération de rang m est effectuée en 3 étapes.

Au cours de la première étape ( étape 322), on effectue un décodage à décisions dures de $x_k^{(m-1)}$. On applique une décision à seuil, symbole par symbole, sur ces symboles dans le sous-ensemble

$B_{\hat{i}k}$, où $\hat{i}_k$ pour k = 1,...7N+4, 8N+5, 8N+6, 8N+7 est la séquence des bits LSB des symboles 4-AM estimés par le décodage itératif du premier étage après la convergence. Cette décision à seuil fournit une première estimation des bits $j_k^{(m)}$, avec $j_k^{(m)} = 0$ (respectivement 1) si la décision dans $B_{\hat{i}k}$ est positive (respectivement négative).

Ensuite on calcule pour chaque symbole $x_k^{(m-1)}$ la valeur absolue de la distance $d(x_k^{(m-1)}, \, t_k^{(m-1)})$ séparant ce symbole du seuil de décision $t_k^{(m-1)}$ dans le sous-ensemble $B_{ik}$, où le seuil dans $B_0 = \{3,-1\}$ (respectivement $B_1 = \{1,-3\}$) est égal à +1 (respectivement -1) et on calcule le minimum $\Delta$ sur k de la distance $d(x_k^{(m-1)}, \, t_k^{(m-1)})$ ainsi que le deuxième minimum $\Delta_2$.

Enfin, on vérifie le bit de parité p des bits $\hat{j}_k^{(m)}$. Si la parité est satisfaite (p=0), la séquence des bits $\hat{j}^{(m)}$ est la séquence optimale. Sinon, on complémente le bit $j_{k_{min}}^{(m)}$ où $k_{min}$ est l'indice donnant le minimum $\Delta$ de $d(x_k^{(m-1)}, \, t_k^{(m-1)})$.

Au cours de la seconde étape, on effectue le calcul des fiabilités (étape 324). La fiabilité de la décision $\hat{j}_k^{(m)}$ est donnée par:

$$FJ_k^{(m)} = (1-2p)\Delta + d(x_k^{(m-1)}, \, t_k^{(m-1)}) \qquad k \neq k_{min}$$

$$FJ_k^{(m)} = (1-2p)\Delta + \Delta 2, \qquad k = k_{min}$$

Ensuite on normalise la fiabilité selon:

$$FJ_k^{norm(m)} = FJ_k^{(m)} / \overline{FJ}$$

où $\overline{FJ}$ est la moyenne des fiabilités $FJ_k^{(m)}$.

Au cours de la troisième étape, on effectue le calcul de la décision douce $X_k^{(m)}$ (étape 326). Cette décision est obtenue en fonction de $t_k^{(m)}$, $j_k^{(m)}$, $FJ_k^{norm(m)}$ par:

$x_k^{(m)} = t_k^{(m)} + 2\ sgn(1-2j_k^{(m)}) \times FJ_k^{norm(m)}$ où sgn(.) est la fonction signe.

L'invention vient d'être décrite dans le cas d'un code convolutif systématique de rendement 7/8. L'homme du métier peut appliquer les mêmes principes de codage et de décodage à d'autres codes convolutifs systématiques de rendement P/(Q.M) combinés à d'autres modulations d'amplitude multidimensionnelles ayant pour dimension Q et disposant de $2^M$ états.

**Revendications**

1. Procédé de protection de données d'entrée mis en oeuvre dans un système de transmission numérique, le procédé comportant une phase de codage desdites données et une phase de décodage itératif, la phase de codage comportant une première étape de codage convolutif systématique en treillis permettant le décodage itératif combinée à une seconde étape d'attribution des données codées à des symboles d'une modulation numérique, **caractérisé en ce que** lors de la première étape, le codage systématique en treillis présente un rendement de codage P/(Q. M), M, P et Q étant des entiers avec Q et M supérieurs à 1, le code convolutif systématique étant utilisé pour générer un code produit en blocs avec fermeture du treillis par ajout de données redondantes, le code produit étant formé de composantes générées par codage de lignes et de colonnes d'une matrice groupant les données codées par le code convolutif systématique, la seconde étape combinant le code produit avec une modulation d'amplitude multidimensionnelle de dimension Q comportant $2^M$ états, le décodage itératif étant un décodage en blocs.

2. Procédé selon la revendication 1 **caractérisé en ce que** le rendement est égal à 7/8, la modulation étant une modulation 8-D à 8 dimensions.

3. Système de transmission numérique à protection de données d'entrée, comportant des moyens de codage desdites données et des moyens de décodage itératif, les moyens de codage comportant:

   - un premier sous-ensemble pour effectuer un codage convolutif systématique en treillis permettant le décodage itératif,
   - un second sous-ensemble pour attribuer les données codées à des symboles d'une modulation numérique,

   **caractérisé en ce que** le premier sous-ensemble met en oeuvre un codage convolutif systématique en treillis de rendement de codage P/(Q.M), M, P et Q étant des entiers avec Q et M supérieurs à 1, le code convolutif systématique étant utilisé pour générer un code produit en blocs avec fermeture du treillis par ajout de données redondantes comportant au moins un bit d'un code de parité, le code produit étant formé de composantes générées par codage de lignes et de colonnes d'une matrice groupant les données codées par le code convolutif systématique, le second sous-ensemble combinant le code produit avec une modulation d'amplitude multidimensionnelle de dimension Q comportant $2^M$ états, le décodage itératif étant un décodage en blocs.

4. Système selon la revendication 3 **caractérisé en ce que** les moyens de codage comportent des moyens, dits machine d'états, pour définir des états successifs du codeur et délivrer les symboles de redondance de fermeture du treillis.

5. Système selon la revendication 3 **caractérisé en ce que** le rendement est égal à 7/8, la modulation étant une modulation 8-D à 8 dimensions, les moyens de codage convolutif systématique codant sept symboles d'entrée en huit symboles de sortie en ajoutant un bit de redondance.

6. Système selon la revendication 5 **caractérisé en ce que** les moyens de codage convolutifs systématiques comportent deux étages de cellules à décalage, les symboles de sortie étant obtenus en combinant linéairement les données issues des cellules à décalage.

7. Système selon une des revendications 3 à 6 **caractérisé en ce que** les moyens de décodage itératifs comportent au moins deux voies opérant successivement:

- sur une première voie, le système met en oeuvre, à chaque itération de la voie, un premier décodage itératif avec:

  a) des moyens pour calculer des décisions dures se rapportant au code convolutif systématique,
  b) des moyens pour calculer des premières fiabilités des décisions dures associées à chaque sous-ensemble de la modulation multidimensionnelle, et des secondes fiabilités associées au treillis du code convolutif systématique,
  c) des moyens pour sélectionner des fiabilités minimales entre les premières et secondes fiabilités de chaque décision,
  d) des moyens pour calculer des décisions douces servant à l'itération suivante de la première voie en fonction des fiabilités minimales sélectionnées et des décisions dures,

- et sur une seconde voie, le système met en oeuvre, à chaque itération de la voie:

  a) des moyens pour calculer des décisions dures se rapportant au code de parité,
  b) des moyens pour calculer des troisièmes fiabilités pour chaque décision dure de la seconde voie en fonction des décisions dures de la première voie,
  c) des moyens pour calculer des décisions douces en fonction des troisièmes fiabilités, des décisions douces issues de l'itération précédente de la seconde voie et des décisions dures de la première voie.

**Patentansprüche**

1. Verfahren zum Schutz von Eingangsdaten, das in einem digitalen Übertragungssystem eingesetzt wird, wobei das Verfahren eine Phase der Codierung der genannten Daten und eine Phase der iterativen Decodierung umfasst, wobei die Phase der Codierung einen ersten Schritt der systematischen Trellis-Faltungscodierung umfasst, die die iterative Decodierung ermöglicht, kombiniert mit einem zweiten Schritt der Zuordnung der codierten Daten zu Symbolen einer digitalen Modulation, **dadurch gekennzeichnet, dass** bei dem ersten Schritt die systematische Trellis-Codierung eine Codierleistung P/(Q.M) aufweist, wobei M, P und Q ganze Zahlen und Q und M größer als Eins sind, wobei der systematische Faltungscode verwendet wird, um einen Produktcode in Blöcken mit Schließen des Trellis durch Hinzufügen von redundanten Daten zu erzeugen und der Produktcode aus Bestandteilen besteht, die durch Codierung von Zeilen und Spalten einer Matrix erzeugt werden, die die durch den systematischen Faltungscode codierten Daten zusammenfasst, wobei der zweite Schritt den Produktcode mit einer multidimensionalen Amplitudenmodulation mit der Dimension Q verknüpft, die $2^M$ Zustände umfasst, und die iterative Decodierung eine Blockdecodierung ist.

2. Verfahren nach Anspruch 1, **dadurch gekennzeichnet, dass** der Wirkungsgrad 7/8 beträgt und die Modulation eine 8-D-Modulation mit 8 Dimensionen ist.

3. System zur digitalen Übertragung mit Schutz der Eingangsdaten, das Mittel zum Codieren der genannten Daten und Mittel zum iterativen Decodieren umfasst, wobei die Mittel zum Codieren Folgendes beinhalten:

- ein erstes Teilsystem, um eine systematische Trellis-Faltungscodierung durchzuführen, die die iterative Decodierung ermöglicht,
- ein zweites Teilsystem, um die codierten Daten Symbolen einer digitalen Modulation zuzuordnen,

**dadurch gekennzeichnet dass** das erste Teilsystem eine systematische Trellis-Faltungscodierung mit einem Codierwirkungsgrad von P/(Q.M) verwendet, wobei M, P und Q ganze Zahlen, Q und M größer als Eins sind und der systematische Faltungscode dazu verwendet wird, einen Produktcode in Blöcken mit Schließen des Trellis durch Hinzufügen von redundanten Daten, die mindestens ein Bit eines Paritätscodes enthalten, zu erzeugen, wobei der Produktcode aus Bestandteilen besteht, die durch Codierung der Zeilen und Spalten einer Matrix erzeugt werden, die die durch den systematischen Faltungscode codierten Daten zusammenfasst, und dass das zweite Teilsystem den Produktcode mit einer multidimensionalen Amplitudenmodulation mit der Dimension Q verknüpft, die $2^M$ Zustände umfasst, wobei die iterative Decodierung eine Blockdecodierung ist.

4. System nach Anspruch 3, **dadurch gekennzeichnet, dass** die Codiermittel Mittel, so genannte Zustandsmaschinen, umfassen, die aufeinander folgende Zustände der Codiereinheit definieren und die Redundanzsymbole zum Schließen des Trellis liefern.

5. System nach Anspruch 3, **dadurch gekennzeichnet, dass** der Wirkungsgrad 7/8 beträgt und die Modulation eine 8-D-Modulation mit 8 Dimensionen ist, wobei die systematischen Faltungscodiermittel sieben Eingangssymbole in acht Ausgangssymbole codieren, indem sie ein Redundanzbit hinzufügen.

6. System nach Anspruch 5, **dadurch gekennzeichnet, dass** die systematischen Faltungscodiermittel zwei Stufen mit Verzögerungsgliedern beinhalten, wobei die Ausgangssymbole erzielt werden, indem die von den Verzögerungsgliedern ausgehenden Daten linear verknüpft werden.

7. System nach den Ansprüchen 3 bis 6, **dadurch gekennzeichnet, dass** die iterativen Decodiermittel mindestens zwei Pfade beinhalten, die nacheinander funktionieren:

   - Auf einem ersten Pfad führt das System bei jeder Iteration des Pfades eine erste iterative Decodierung durch mit:

      a) Mitteln zum Berechnen der Hard Decisions, die sich auf den systematischen Faltungscode beziehen,
      b) Mitteln zum Berechnen der ersten Zuverlässigkeiten der zu jedem Teilsystem der multidimensionalen Modulation gehörigen Hard Decisions, und der zweiten zum Trellis des systematischen Faltungscode gehörigen Zuverlässigkeiten,
      c) Mitteln zum Auswählen der minimalen Zuverlässigkeiten aus den ersten und zweiten Zuverlässigkeiten jeder Entscheidung,
      d) Mitteln zum Berechnen der Soft Decisions, die zur folgenden Iteration des ersten Pfades dienen, in Abhängigkeit von den ausgewählten minimalen Zuverlässigkeiten und den Hard Decisions,

   - und auf einem zweiten Pfad nutzt das System bei jeder Iteration des Pfades:

      a) Mittel zum Berechnen der Hard Decisions, die sich auf den Paritätscode beziehen,
      b) Mittel zum Berechnen der dritten Zuverlässigkeiten für jede harte Hard Decision des zweiten Pfades in Abhängigkeit von den Hard Decisions des ersten Pfades,
      c) Mittel zum Berechnen der Soft Decisions in Abhängigkeit von den dritten Zuverlässigkeiten, den aus der vorhergehenden Iteration des zweiten Pfades hervorgegangenen Soft Decisions und den Hard Decisions des ersten Pfades.

8. Decodierverfahren zum Decodieren der vorher codierten Symbole unter Verwendung eines auf einem systematischen Trellis-Faltungscode basierenden Produktcodes mit einem Codierwirkungsgrad P/(Q.M), wobei M,P und Q ganze Zahlen und Q und M größer 1 sind, mit Schließen des genannten Trellis durch Hinzufügen von redundanten Daten, die mindestens ein Bit eines Paritätscodes enthalten, wobei der genannte Produktcode mit einer multidimensionalen Amplitudenmodulation der Dimension Q mit $2^M$ Zuständen verknüpft ist und die genannte Modulation in Teilsysteme unterteilt ist, wobei das genannte Decodierverfahren mindestens einen ersten und einen zweiten iterativen Schritt umfasst, die nacheinander durchgeführt werden:

   - wobei der genannte erste iterative Schritt bei jeder Iteration folgende Schritte beinhaltet:

      a) Berechnung der Hard Decisions in Bezug auf den systematischen Faltungscode,
      b) Berechnung von ersten Zuverlässigkeiten der jedem Teilsystem der multidimensionalen Modulation zugeordneten Hard Decisions und von zweiten Zuverlässigkeiten, die dem Trellis des systematischen Faltungscode zugeordnet sind,
      c) Auswahl der minimalen Zuverlässigkeiten aus den ersten und zweiten Zuverlässigkeiten jeder Entscheidung,
      d) Berechnung von Soft Decisions, die zur folgenden Iteration des genannten ersten Schritts dienen, in Abhängigkeit von den ausgewählten minimalen Zuverlässigkeiten und den Hard Decisions,

   - und wobei der genannte zweite iterative Schritt bei jeder Iteration folgende Schritte beinhaltet:

      a) Berechnung der Hard Decisions in Bezug auf den Paritätscode,
      b) Berechnung von dritten Zuverlässigkeiten für jede Hard Decision des genannten zweiten iterativen Schritts in Abhängigkeit von den Hard Decisions des genannten ersten iterativen Schritts,
c) Berechnung von Soft Decisions in Abhängigkeit von den dritten Zuverlässigkeiten, von aus der vorhergehenden Iteration des zweiten iterativen Schritts hervorgegangenen Soft Decisions, und von Hard Decisions des genannten ersten iterativen Schritts.

**Claims**

1. A method of protecting input data implemented in a digital transmission system, the method comprising a coding phase for said data and an iterative decoding phase, the coding phase comprising a first step for performing a systematic convolutional trellis coding permitting of the iterative decoding combined with a second step for assigning the coded data to digitally modulated symbols, **characterized in that** during the first step the systematic trellis coding has a coding rate P/(Q.M), where M, P and Q are integers with Q and M being greater than 1, the systematic convolutional code being used for generating a product code in blocks with trellis closure by the addition of redundant data, the product code being formed by components generated by row coding and column coding of a matrix that combines the coded data via the systematic convolutional code, whereas the second step combines the product code with a multidimensional amplitude modulation having dimension Q that has $2^M$ states, the iterative decoding being a block decoding.

2. A method as claimed in claim 1, **characterized in that** the rate is equal to 7/8, the modulation being an 8-D modulation having 8 dimensions.

3. A digital transmission system with input data protection, comprising coding means of said data and iterative decoding means, the coding means comprising:

   - a first sub-set for performing a systematic convolutional trellis coding permitting of the iterative decoding
   - and a second sub-set for assigning the coded data to digitally modulated symbols,

   **characterized in that** the first sub-set utilizes a systematic convolutional trellis coding having a coding rate P/(Q.M), where M, P and Q are integers with Q and M being greater than 1, the systematic convolutional code being used for generating a product code in blocks with trellis closure by the addition of redundant data which comprise at least one parity code bit, the product code being formed by components generated by row coding and column coding of a matrix that combines the coded data via the systematic convolutional code, whereas the second sub-set combines the product code with a multidimensional amplitude modulation having dimension Q that has $2^M$ states, the iterative decoding being a block decoding.

4. A system as claimed in claim 3, **characterized in that** the coding means comprise a means called state machine for defining successive states of the coder and producing the trelllis closing redundancy symbols.

5. A system as claimed in claim 3, **characterized in that** the rate is equal to 7/8, the modulation being an 8-D modulation having 8 dimensions, the systematic convolutional coding means coding seven input symbols into eight output symbols by adding one redundancy bit.

6. A system as claimed in claim 5, **characterized in that** the systematic convolutional coding means comprise two shift-cell stages, the output symbols being obtained by linearly combining the data coming from the shift cells.

7. A system as claimed in any one of the claims 3 to 6, **characterized in that** the iterative decoding means comprise at least two paths operating in succession:

   - along a first path, the system carries out with each iteration of the path a first iterative decoding with:

     a) computing means for computing hard decisions which relate to the systematic convolutional code,
     b) computing means for computing first reliabilities of the hard decisions associated with each multidimensional modulation sub-set, and second reliabilities associated to the trellis of the systematic convolutional code,
     c) selecting means for selecting minimum reliabilities between the first and second reliabilities of each decision,
     d) computing means for computing soft decisions used for the next iteration of the first path as a function of selected minimum reliabilities and hard decisions,

- and along a second path, the system utilizes for each iteration of the path:

  a) computing means for computing hard decisions which relate to the parity code,
  b) computing means for computing third reliabilities for each hard decision of the second path as a function of hard decisions of the first path,
  c) computing means for computing soft decisions as a function of the third reliabilities, soft decisions coming from the preceding iteration of the second path and hard decisions from the first path.

8. A decoding method for decoding previously coded symbols by utilizing a product code based on a systematic convolutional trellis code, having coding rate $P/(Q.M)$, M, P and Q being integers with Q and M being greater than 1, with closing of said trellis by the addition of redundancy data comprising at least one parity code bit, said product code being combined with a multidimensional amplitude modulation of size Q comprising $2^M$ states, said modulation being partitioned into sub-sets, said decoding method comprising at least a first and a second iterative step carried out successively:

   - said first iterative step comprising for each iteration steps of:

     a) computing hard decisions which relate to the systematic convolutional code,
     b) computing first reliabilities of the hard decisions associated with each multidimensional modulation sub-set, and second reliabilities associated with the trellis of the systematic convolutional code,
     c) selecting minimum reliabilities between the first and second reliabilities of each decision.
     d) computing soft decisions used for the next iteration of said first step as a function of selected minimum reliabilities and hard decisions,

   - and said second iterative step comprising for each iteration of the steps:

     a) computing hard decisions which relate to the parity code,
     b) computing third reliabilities for each hard decision of said second iterative step as a function of hard decisions of the first iterative step,
     c) computing soft decisions as a function of the third reliabilities, soft decisions coming from the preceding iteration step and hard decisions from said first iterative step.

**FIG.1**

**FIG.2**

**FIG.3**

**FIG.4**

FIG.5

$\sigma_K$           $\sigma_{K+1}$

$(S_{0,0}\ S_{2,1}\ S_{12,0}\ S_{14,1}\ S_{4,1}\ S_{6,0}\ S_{8,1}\ S_{10,0})$   0 0 0        0 0 0

$(S_{6,1}\ S_{4,0}\ S_{10,1}\ S_{8,0}\ S_{2,0}\ S_{0,1}\ S_{14,0}\ S_{12,1})$   0 0 1        0 0 1

$(S_{2,1}\ S_{0,0}\ S_{14,1}\ S_{12,0}\ S_{6,0}\ S_{4,1}\ S_{10,0}\ S_{8,1})$   0 1 0        0 1 0

$(S_{4,0}\ S_{6,1}\ S_{8,0}\ S_{10,1}\ S_{0,1}\ S_{2,0}\ S_{12,1}\ S_{14,0})$   0 1 1        0 1 1

$(S_{12,0}\ S_{14,1}\ S_{0,0}\ S_{2,1}\ S_{8,1}\ S_{10,0}\ S_{4,1}\ S_{6,0})$   1 0 0        1 0 0

$(S_{10,1}\ S_{8,0}\ S_{6,1}\ S_{4,0}\ S_{14,0}\ S_{12,1}\ S_{2,0}\ S_{0,1})$   1 0 1        1 0 1

$(S_{14,1}\ S_{12,0}\ S_{2,1}\ S_{0,0}\ S_{10,0}\ S_{8,1}\ S_{6,0}\ S_{4,1})$   1 1 0        1 1 0

$(S_{8,0}\ S_{10,1}\ S_{4,0}\ S_{6,1}\ S_{12,1}\ S_{14,0}\ S_{0,1}\ S_{2,0})$   1 1 1        1 1 1

**FIG.6**

EP 0 848 501 B1

FIG.7

FIG.8

FIG.9

FIG.10

FIG.11

FIG.12

FIG.13

FIG 14

FIG.15

EP 0 848 501 B1

$x_k^{(m-1)}$ $\qquad$ $\hat{i}_k$ $\qquad$ $t_k^{(m-1)}$ $\qquad$ $FJ_k^{norm(m)}$ $\qquad$ 326

322 $\qquad$ 324 $\qquad$ $x_k^{(m)}$

$\hat{j}_k^{(m)}$

**FIG.16**

**FIG.17**